(19) Europäisches Patentamt
European Patent Office
Office européen des brevets

(11) EP 3 573 120 A1

(12) **EUROPEAN PATENT APPLICATION**
published in accordance with Art. 153(4) EPC

(43) Date of publication:
**27.11.2019 Bulletin 2019/48**

(21) Application number: **18742158.1**

(22) Date of filing: **18.01.2018**

(51) Int Cl.:
***H01L 51/50*** *(2006.01)* ***H05B 33/10*** *(2006.01)*

(86) International application number:
**PCT/JP2018/001380**

(87) International publication number:
**WO 2018/135580 (26.07.2018 Gazette 2018/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **18.01.2017 JP 2017006991**
**28.06.2017 JP 2017126778**

(71) Applicant: **Nissan Chemical Corporation**
**Tokyo 103-6119 (JP)**

(72) Inventors:
- **NAKAIE Naoki**
**Funabashi-shi**
**Chiba 274-0052 (JP)**
- **YOSHITAKE Keiko**
**Sodegaura -shi**
**Chiba 299-0266 (JP)**

(74) Representative: **Mewburn Ellis LLP**
**City Tower**
**40 Basinghall Street**
**London EC2V 5DE (GB)**

# (54) CHARGE-TRANSPORTING VARNISH AND CHARGE-TRANSPORTING THIN FILM

(57) Disclosed are a charge transporting varnish comprising a specific oligoaniline compound, an electron accepting dopant, a metal oxide nanoparticle, and an organic solvent; a charge transporting film prepared from the charge transporting varnish; an electronic device and an organic electroluminescent device having the charge transporting film; and a method for producing the charge transporting film using the charge transporting varnish.

EP 3 573 120 A1

## Description

### TECHNICAL FIELD

This application claims priority to Japanese Patent Application No. 2017-006991, filed on Jan. 18, 2017, and Japanese Patent Application No. 2017-126778, filed Jun. on 28, 2017. The entire contents of these applications are expressly incorporated herein by this reference.

The present invention relates to a charge transporting varnish. More particularly, the present invention relates to a charge transporting varnish comprising particular components and a charge transporting thin film formed using the same.

### BACKGROUND ART

In recent years, oligoaniline compounds have been used as the charge transporting material in the hole injection layer in organic electroluminescence (hereinafter referred to as "organic EL") devices, and efforts are being made to improve various properties of these compounds. Examples of such properties include charge transportability, and luminous efficacy and luminance characteristics when used in an organic EL device, as well as solubility, in particular in an organic solvent, for compatibility with various coating methods such as spin coating, ink jet coating, spray coating, and the like, which are used when coating a charge transporting varnish containing these compounds to form a hole injection layer.

The present inventors have reported that oligoaniline compounds having a specific chemical structure exhibit good solubility in an organic solvent, show high charge transportability when used in combination with a charge accepting substance, and can exhibit high luminous efficacy and luminance characteristics when used as the charge transporting substance in the hole injection layer of an organic EL device (see Patent Document 1).

It is desirable that a charge transporting film such as the hole injection layer of an organic EL device have high light transmittance in the visible region and be not colored. The coloration of the charge transporting film is known to lower the color purity and color reproducibility of organic EL devices. Moreover, such coloration presents a problem in various full-color techniques for organic EL displays, such as tricolor luminescence, white color luminescence, and color conversion, and becomes a considerable obstacle in the stable manufacture of organic EL devices. The problem is, however, that since most oligoaniline compounds are colored substances, forming a charge transporting film using an oligoaniline compound results in a colored film. An oligoaniline compound typically has a structure consisting of a plurality of identical repeating units in a chain inside the molecule, and as the number of repeating units increases, leading to the extension of the conjugate system thereof, absorbance in the visible region increases (light transmittance decreases), resulting in a significant coloration of the charge transporting film.

It is known that a charge transporting film having high light transmittance in the visible region with suppressed coloration can be obtained by using an oligoaniline compound in which the conjugated system in the molecule is partially severed or an oligoaniline compound containing as a part thereof a conjugated system composed of a repeating unit other than an aniline unit (for example, see Patent Document 2). However, films with less coloration have been desired for improvement in light extraction efficiency and the like. In addition, organic EL devices having such a film have room for improvement in terms of device characteristics, lifetime performance, and the like.

Patent Document 1: WO 2008/129947
Patent Document 2: WO 2008/032616
Patent Document 3: Japanese Unexamined Patent Application Publication (Translation of PCT Application) No. 2012-524834
Patent Document 4: Japanese Unexamined Patent Application Publication (Translation of PCT Application) No. 2012-520381
Patent Document 5: Japanese Patent No. 5381931
Patent Document 6: Japanese Unexamined Patent Application Publication No. 2002-151272
Non-Patent Document 1: Advanced Materials, 2011, 23(6), pp. 740-745

### SUMMARY

#### Problems to be Solved by the Invention

The present invention has been made in view of the above circumstances, and an object thereof is to provide a charge transporting varnish that provides a charge transporting film having high light transmittance in the visible region and less coloration while using an oligoaniline compound as a charge transporting substance, and a charge transporting

film obtained using such a charge transporting varnish.

**Means for Solving the Problems**

The present inventors have carried out intensive investigations in order to achieve the object above. As a result, the present inventors have surprisingly found that, in a charge transporting varnish, use of a particular oligoaniline compound, along with an electron accepting dopant for imparting charge transportability, in combination with a metal oxide nanoparticle significantly improves the light transmittance in the visible region of the resulting charge transporting film without altering the chemical structure of the oligoaniline compound itself, thereby greatly reducing the coloration of the charge transporting film, as well as further improving other characteristics. Based on the new findings above, the present invention has been completed.

That is, the present invention provides the following inventions.

1. A charge transporting varnish comprising an oligoaniline compound, an electron accepting dopant, a metal oxide nanoparticle, and an organic solvent.
2. The charge transporting varnish according to preceding item 1, wherein the oligoaniline compound is at least one selected from the oligoaniline compounds represented by formula (1) and formula (1').

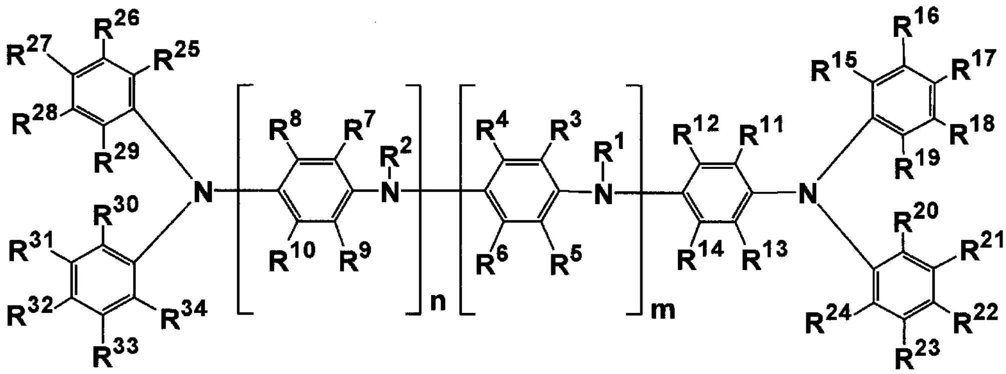

(1)

wherein

$R^1$ and $R^2$ each, independently, represent a hydrogen atom, a substituted or unsubstituted monovalent hydrocarbon group, a t-butoxycarbonyl group, or a benzyloxycarbonyl group;
$R^3$ to $R^{34}$ each, independently, represent a hydrogen atom, a hydroxyl group, a silanol group, a thiol group, a carboxyl group, a phosphoric acid group, a phosphate ester group, an ester group, a thioester group, an amide group, a nitro group, a substituted or unsubstituted monovalent hydrocarbon group, an organoxy group, an organoamino group, an organosilyl group, an organothio group, an acyl group, a sulfonic group or a halogen atom; and
m and n each, independently, represent an integer of 1 or more and satisfy $m + n \leq 20$;

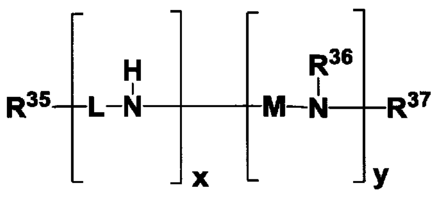

(1')

wherein

$R^{35}$, $R^{36}$, and $R^{37}$ each, independently, represent a hydrogen atom, an unsubstituted or substituted monovalent hydrocarbon group, or an organooxy group;
L and M each, independently, represent a divalent group represented by general formula (6) or (7);
$R^{38}$ to $R^{45}$ each, independently, represent a hydrogen atom, a hydroxyl group, an unsubstituted or substituted monovalent hydrocarbon group, or an organooxy group, an acyl group, or a sulfonic acid group; and
x and y each, independently, represent an integer of 1 or more, and satisfy $x + y \leq 20$.

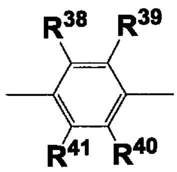

(6)

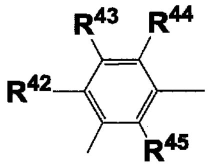

(7)

3. The charge transporting varnish according to preceding item 2, wherein $R^1$ and $R^2$ each, independently, represent a hydrogen atom or t-butoxycarbonyl group; $R^3$ to $R^{34}$ each, independently, represent a hydrogen atom, a substituted or unsubstituted monovalent hydrocarbon group, an organooxy group, an organoamino group, or a halogen atom; and m and n each, independently, represent an integer of 1 or more, and satisfy $m + n \leq 10$.
4. The charge transporting varnish according to preceding item 2 or 3, wherein $R^3$ to $R^{34}$ each, independently, represent a hydrogen atom, a substituted or unsubstituted monovalent hydrocarbon group, or a halogen atom; and m and n each, independently, represent an integer of 1 or more and satisfy $m + n \leq 5$.
5. The charge transporting varnish according to preceding item 3, wherein the monovalent hydrocarbon group in $R^3$ to $R^{34}$ is a phenyl group, a biphenyl group, a naphthyl group, or a substituted or unsubstituted arylamino group.
6. The charge transporting varnish according to preceding item 3, wherein the halogen atom is a fluorine atom.
7. The charge transporting varnish according to preceding item 2, wherein $R^3$ to $R^{34}$ are all hydrogen atoms.
8. A charge transporting varnish comprising a quinonediimine compound which is an oxidized form of the oligoaniline compound according to preceding item 2, an electron accepting dopant, a metal oxide nanoparticle and an organic solvent.
9. The charge transporting varnish according to any one of preceding items 1 to 8, wherein the electron accepting dopant material comprises at least one member selected from the group consisting of an arylsulfonic acid compound, a heteropoly acid compound, and an ionic compound comprising an element belonging to Group 13 of the long periodic table.
10. The charge transporting varnish according to any one of preceding items 1 to 9, wherein the electron accepting dopant material comprises at least one selected from the group consisting of a heteropoly acid compound, an arylsulfonic acid derivative represented by formula (2), and an ionic compound consisting of an anion represented by formula (5a) and a countercation thereof.

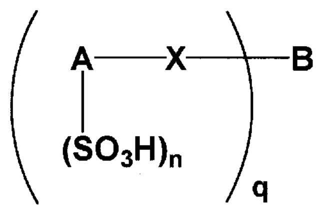

(2)

wherein

X represents O, S or NH;
A represents a naphthalene or anthracene ring which may have a substituent other than X or the n number of $(SO_3H)$ groups;
B represents an unsubstituted or substituted hydrocarbon group, a 1,3,5-triazine group, or an unsubstituted or substituted group represented by formula (3) or (4) below:

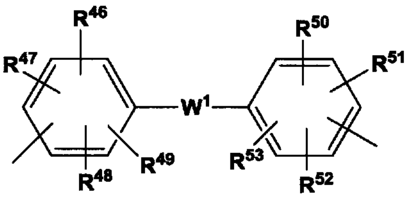
(3)

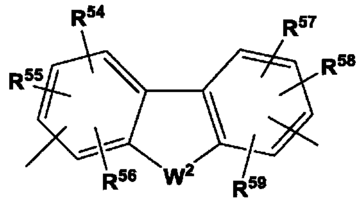
(4)

wherein

W1 and W2 each, independently, represent O, S, an S(O) group, an $S(O_2)$ group, or an unsubstituted or substituted N, Si, P, or P(O) group;
W1 may be a single bond; and
$R^{46}$ to $R^{59}$ each, independently, represent a hydrogen atom or a halogen atom;

n represents the number of sulfonic acid groups attached to A and is an integer satisfying $1 \leq n \leq 4$; and
q represents the number of bonds between B and X and is an integer satisfying $1 \leq q$;

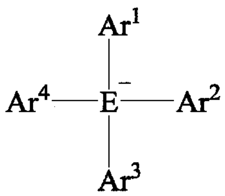
(5a)

wherein E represents an element belonging to Group 13 or 15 of the long periodic table; and $Ar^1$ to $Ar^4$ each, independently, represent an aromatic hydrocarbon group which may have a substituent or an aromatic heterocyclic group which may have a substituent.

11. A charge transporting film formed from the charge transporting varnish according to any one of preceding items 1 to 10.
12. An electronic device comprising the charge transporting film according to preceding item 11.
13. An organic electroluminescence device comprising the charge transporting film according to preceding item 11.
14. A method for producing a charge transporting film comprising: applying the charge transporting varnish according to any one of preceding items 1 to 10 onto a substrate and evaporating a solvent.
15. A charge transporting film comprising an oligoaniline compound and a metal oxide nanoparticle, wherein the average transmittance over the wavelength range of 400 nm to 800 nm is improved by the incorporation of the metal oxide nanoparticle.
16. A charge transporting film comprising an oligoaniline compound and a metal oxide nanoparticle, wherein the average transmittance over the wavelength range of 400 nm to 800 nm is 90% or more when deposited at a thickness of 50 nm on a quartz substrate.

**Effect of the Invention**

Although the charge transporting varnish of the present invention contains as the charge transporting substance a conventional oligoaniline compound, which is a colored substance, a charge transporting film produced using the charge transporting varnish has a remarkably improved light transmittance in the visible region as compared with that produced using a conventional charge transporting varnish, thereby greatly reducing the coloration of the charge transporting film and leading to an observed remarkable improvement in other characteristics. The use of the charge transporting varnish of the present invention, therefore, can remarkably improve various characteristics of not only the obtained charge transporting film but also an organic EL device manufactured using the film, without altering the chemical structure of conventional oligoaniline compounds.

## Brief Description of the Drawings

FIG. 1 is a graph showing light transmittance in the visible region for films formed on quartz substrates from the charge transporting varnish of the present invention and a conventional charge transporting varnish (Example 2-1 and Comparative Example 2-1, respectively).

FIG. 2 is a graph showing light transmittance in the visible region for films formed on quartz substrates from the charge transporting varnish of the present invention and a conventional charge transporting varnish (Example 2-2 and Comparative Example 2-2, respectively).

## Detailed Description of Preferred Embodiments

Hereinafter, the present invention will be described in more detail.

The oligoaniline compound contained in the charge transporting varnish of the present invention is a compound composed of a plurality of structural units, which may be the same or different, derived from aniline derivatives, having an average molecular weight of 200 to 5,000. In the oligoaniline compound, two adjacent structural units are bonded to each other. When the oligoaniline compound comprises two or more different structural units, the structural units may be arranged in any order. In the present invention, any oligoaniline compound may be used as a charge transporting substance, but, preferably, an oligoaniline compound represented by the following formula (1) or (1') is contained (WO 2008/129947 (Patent Document 1) and WO 2002-151272 (Patent Document 6)).

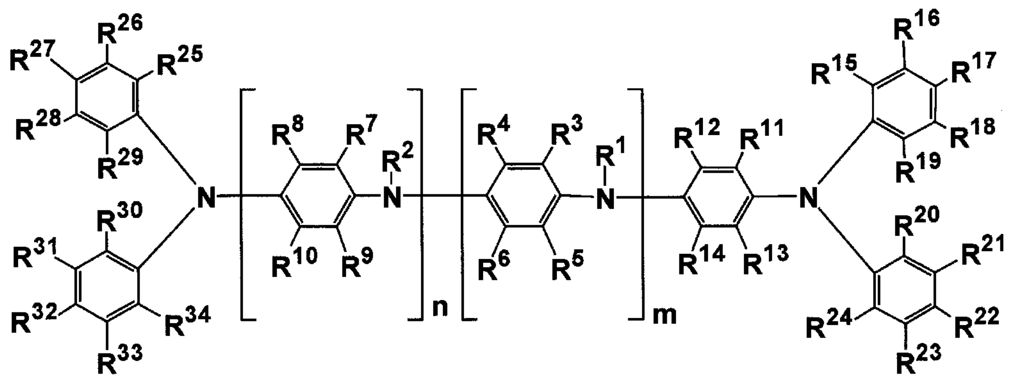

(1)

wherein

$R^1$ and $R^2$ each, independently, represent a hydrogen atom, a substituted or unsubstituted monovalent hydrocarbon group, a t-butoxycarbonyl group, or a benzyloxycarbonyl group;

$R^3$ to $R^{34}$ each, independently, represent a hydrogen atom, a hydroxyl group, a silanol group, a thiol group, a carboxyl group, a phosphoric acid group, a phosphate ester group, an ester group, a thioester group, an amide group, a nitro group, a substituted or unsubstituted monovalent hydrocarbon group, an organoxy group, an organoamino group, an organosilyl group, an organothio group, an acyl group, a sulfonic group or a halogen atom; and

m and n each, independently, represent an integer of 1 or more and satisfy $m + n \leq 20$;

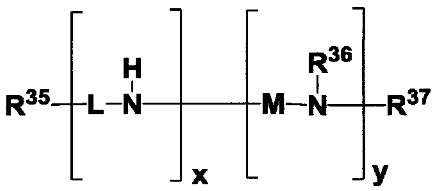

(1')

wherein

$R^{35}$, $R^{36}$, and $R^{37}$ each, independently, represent a hydrogen atom, an unsubstituted or substituted monovalent hydrocarbon group, or an organooxy group;

L and M each, independently, represent a divalent group represented by general formula (6) or (7);

$R^{38}$ to $R^{45}$ each, independently, represent a hydrogen atom, a hydroxyl group, an unsubstituted or substituted monovalent hydrocarbon group, or an organooxy group, an acyl group, or a sulfonic acid group; and
x and y each, independently, represent an integer of 1 or more, and satisfy $x + y \leq 20$.

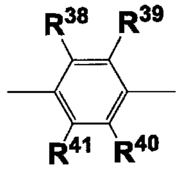
(6)

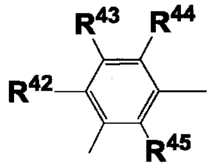
(7)

The monovalent hydrocarbon group mentioned above is not specifically restricted in carbon number; however, it should preferably have a carbon number of 1 to 20, more preferably 1 to 8.
Examples of the substituted or unsubstituted monovalent hydrocarbon group include alkyl groups, such as methyl group, ethyl group, n-propyl group, i-propyl group, n-butyl group, i-butyl group, t-butyl group, n-hexyl group, n-octyl group, 2-ethylhexyl group, and decyl group; cycloalkyl groups, such as cyclopentyl group and cyclohexyl group; bicycloalkyl groups, such as bicyclohexyl group; alkenyl groups, such as vinyl group, 1-propenyl group, 2-propenyl group, 1-methyl-2-propenyl group, 1- or 2- or 3-butenyl group, and hexenyl group; aryl groups, such as phenyl group, xylyl group, tolyl group, biphenyl group, and naphthyl group; and aralkyl groups, such as benzyl group, phenylethyl group, and phenylcyclohexyl group. These monovalent hydrocarbon groups may have their hydrogen atoms partly or entirely substituted with halogen atoms, hydroxyl groups, alkoxyl groups, sulfonic groups, or the like.
Incidentally, "unsubstituted" means connection of hydrogen atoms. Also, substituent groups may link with each other to form a cyclic structure.
$R^1$ and $R^2$ in the above each, independently, are, preferably, a hydrogen atom, methyl group, ethyl group, or t-butoxycarbonyl group, of which a hydrogen atom or t-butoxycarbonyl group is particularly preferable.
In other words, preferred embodiments are those in which both $R^1$ and $R^2$ are hydrogen atoms or t-butoxycarbonyl groups, $R^1$ is a hydrogen atom and $R^2$ is a t-butoxycarbonyl group, or $R^1$ is a t-butoxycarbonyl group and $R^2$ is a hydrogen atom.
In the formula (1) above, $R^3$ to $R^{34}$ each, independently, represent a hydrogen atom, hydroxyl group, amino group, silanol group, thiol group, carboxyl group, phosphoric acid group, phosphate ester group, ester group, thioester group, amide group, nitro group, substituted or unsubstituted monovalent hydrocarbon group, organooxy group, organoamino group, organosilyl group, organothio group, acyl group, sulfonic group, halogen atom, or the like.
Examples of the substituted or unsubstituted monovalent hydrocarbon group are the same as those listed above.
Examples of the organooxy group include alkoxyl groups, alkenyloxy groups, aryloxy groups, and the like. These alkyl groups and alkenyl groups are also exemplified by the same substituent groups listed above.
Examples of the organoamino group include alkylamino groups, such as methylamino group, ethylamino group, propylamino group, butylamino group, pentylamino group, hexylamino group, heptylamino group, octylamino group, nonylamino group, decylamino group, and laurylamino group; dialkylamino groups, such as dimethylamino group, diethylamino group, dipropylamino group, dibutylamino group, dipentylamino group, dihexylamino group, diheptylamino group, dioctylamino group, dinonylamino group, and didecylamino group; cycloalkylamino groups such as cyclohexylamino group; dicycloalkylamino groups, such as dicyclohexylamino group; morpholino group; and arylamino groups, such as biphenylamino group.
Examples of the organosilyl group include trimethylsilyl group, triethylsilyl group, tripropylsilyl group, tributylsilyl group, tripentylsilyl group, trihexylsilyl group, pentyldimethylsilyl group, hexyldimethylsilyl group, octyldimethylsilyl group, and decyldimethylsilyl group.
Examples of the organothio group include alkylthio groups, such as methylthio group, ethylthio group, propylthio group, butylthio group, pentylthio group, hexylthio group, heptylthio group, octylthio group, nonylthio group, decylthio group, and laurylthio group.
Examples of the acyl group include formyl group, acetyl group, propionyl group, butylyl group, isobutylyl group, valeryl group, isovaleryl group, and benzoyl group.
Examples of the halogen atom include chlorine, bromine, fluorine, and iodine atoms.

The phosphate ester group is exemplified by -P(O)(OQ$^1$)(OQ2).

The ester group is exemplified by -C(O)OQ$^1$ and -OC(O)Q$^1$.

The thioester group is exemplified by -C(S)OQ$^1$ and -OC(S)Q$^1$.

The amide group is exemplified by -C(O)NHQ$^1$, -NHC(O)Q$^1$, -C(O)NQ$^1$Q$^2$ and -NQ$^1$C(O)Q$^2$.

Here, the foregoing Q$^1$ and Q$^2$ denote an alkyl group, alkenyl group, or aryl group; examples thereof include the same as those listed for the monovalent hydrocarbon group in the above.

The foregoing monovalent hydrocarbon group, organooxy group, organoamino group, organosilyl group, organothio group, acyl group, phosphate ester group, ester group, thioester group, and amide group denoted by $R^3$ to $R^{34}$ are not specifically restricted in carbon number. However, their carbon number is typically 1 to 20, preferably 1 to 8.

Preferable among these groups, which are denoted by $R^3$ to $R^{34}$ mutually independently, are a hydrogen atom, substituted or unsubstituted monovalent hydrocarbon group, organooxy group, organoamino group, and halogen atom. Particularly preferable among them are a hydrogen atom, substituted or unsubstituted monovalent hydrocarbon group, and halogen atom.

Preferred monovalent hydrocarbon groups are phenyl groups, biphenyl groups, and naphthyl groups.

Preferred halogen atoms are fluorine atoms. Preferred organoamino groups are arylamino groups, especially biphenylamino groups.

In an embodiment, $R^3$ to $R^{34}$ are all hydrogen atoms.

In an embodiment, $R^{37}$ is a phenyl group which may have a substituent.

In the formula (1) above, m and n each, independently, represent an integer of 1 or more, and satisfy $m+n \leq 20$, preferably $m+n \leq 10$, more preferably $m+n \leq 5$.

Adjustment to these ranges allows easy realization of high solubility in various solvents while maintaining good charge transportability.

The oligoaniline compound represented by formula (1) should preferably has no molecular weight distribution, or, stated differently, has a degree of dispersion of 1 for achieving both high solubility and uniform charge transportability.

The lower limit of the molecular weight is typically 200 or higher, preferably 400 or higher, for curving material volatility and achieving good charge transportability. The upper limit is typically 5000 or lower, preferably 3000 or lower, for good solubility.

The oligoaniline compound represented by formula (1) above may be produced using the following method, for example.

The oligoaniline compound (8) shown below has its halogen atoms (X) reacted by the amine compounds having a triphenylamine structure represented by formulas (9) and (10). Alternatively, the oligoaniline compound (8') shown below has its halogen atoms (X) reacted by the amine compounds having a diphenylamine structure represented by formulas (9') and (10'). The procedure for these reactions is not specifically restricted, and, for example, common nucleophilic substitution reactions may be employed.

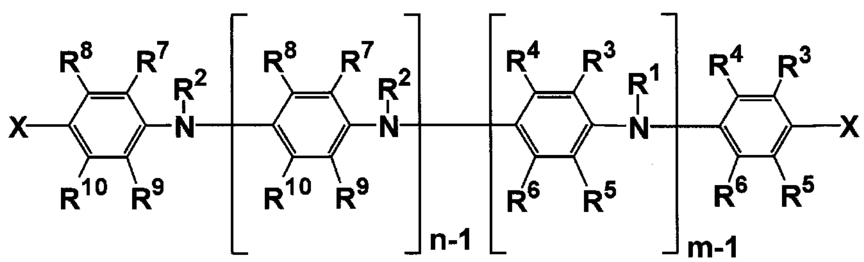

(8)

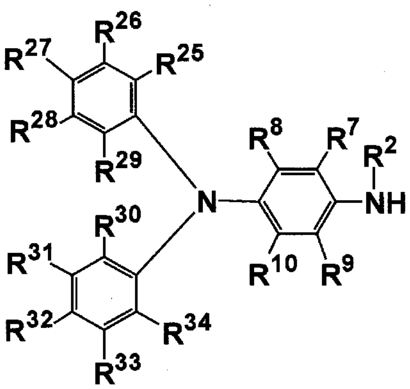
(9)

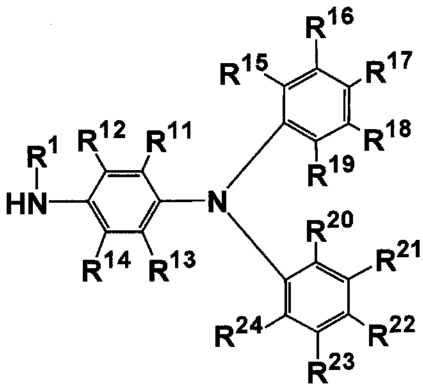
(10)

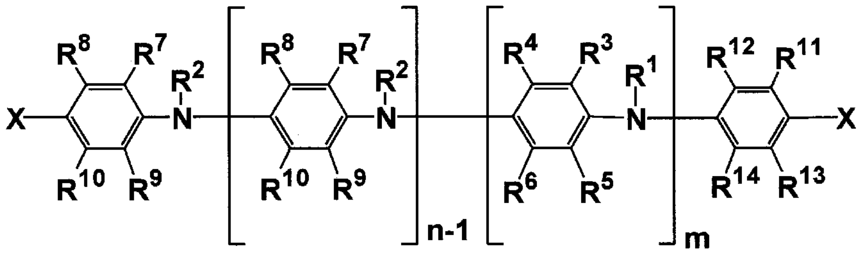
(8')

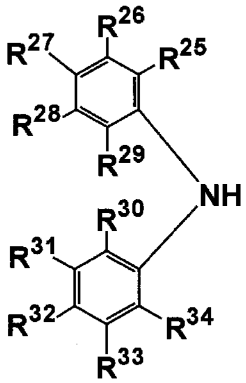
(9')

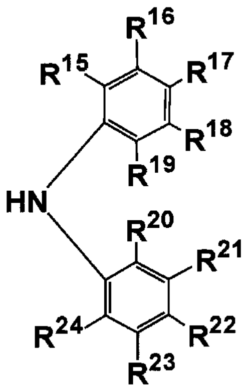
(10')

For oligoaniline compounds (8) and (8'), compounds having amino groups protected by protecting groups may be used. Examples of protecting groups include a t-butoxycarbonyl group or benzyloxycarbonyl group, referred to in the above, for example.

The amine compounds represented by formulas (9) and (9') or formulas (10) and (10') should preferably be used in an amount, in mole, twice as much as the oligoaniline compound (8) or (8').

The reaction of oligoaniline compound (8) with the amine compound represented by formula (9) or (9'), or (10) or (10'), may optionally be catalyzed. Examples of catalysts include, for example, palladium acetate (II), tris(dibenzylideneacetone) palladium (0), bis(dibenzylideneacetone) palladium (0), and (1,1'-bis-(diphenylphosphino)ferrocene) dichloropalladium. Examples of ligands include, for example, (tri-t-butylphosphine), (2,2'-bis-(diphenylphosphino)-1,1'-binaphthyl), and (tri-o-toluylphosphine). Examples of bases include, for example, NaOtBu, $CsCO_3$, $K_2CO_3$, and NaOPh. Examples of solvents include, for example, toluene, xylene, THF, NMP, DMF, and 1,4-dioxane.

The reaction temperature is preferably 0 to 160°C. The reaction time typically ranges from 0.1 to 100 hours. The reaction may be followed by removal of the reaction solvent by distillation, removal of inorganic salts by solid-liquid extraction or liquid-liquid extraction, and purification by recrystallization, silica gel chromatography, etc.

In case an oligoaniline compound having protected amino groups is used, its protecting groups may be removed by treatment with a strong acid such as trifluoroacetic acid and hydrochloric acid.

Also, if the charge transporting varnish contains an oligoaniline compound having protected amino groups and an acid dopant, it may be used without further treatment as the charge transporting material because the protecting groups come off at the time of forming a film.

In particular, oligoaniline compounds having protected amino groups dissolves more readily in organic solvents

than those having no protected amino groups, and therefore are suitable as a highly soluble host.

The substituents $R^{35}$ and $R^{36}$ to $R^{45}$ in the oligoaniline moiety of formula (1') are typically hydrogen, but an alkyl group, an alkoxy group, a cyclohexyl group, a biphenyl group, a bicyclohexyl group, a phenylcyclohexyl group, and the like are suitable for improving solubility in a solvent. Typical examples of alkyl groups include a methyl group, an ethyl group, a propyl group, and the like, and the number of carbon atoms is typically from 1 to 4, but up to 20 carbon atoms may be introduced. The numbers x and y in the oligoaniline moiety are each, independently, an integer of 1 or more, but 2 or more is preferable in consideration of conductivity, and 20 or less is preferable in consideration of solubility in a solvent.

For the substituent $R^{36}$, a hydrogen atom, a hydroxyl group, an unsubstituted or substituted monovalent hydrocarbon group, an organooxy group, an acyl group, an alkyl group having 1 to 20 carbon atoms, or an alkoxy group having 1 to 20 carbon atoms is suitable. Typical examples of alkyl groups include a methyl group, an ethyl group, a propyl group, and the like, and the number of carbon atoms is typically from 1 to 4, but up to 20 carbon atoms may be introduced.

The charge transporting varnish according to the present invention contains as the charge transporting material the oligoaniline compound represented by formula (1) or formula (1') or a quinonediimine compound which is an oxidized form of the oligoaniline compound.

Here, the charge transporting varnish is a product formed by dissolving or dispersing in at least one solvent the charge transporting material consisting of the oligoaniline compound represented by formula (1) or formula (1'), which is the main component of the charge transporting mechanism, and an electron accepting dopant, followed by further dispersing a metal oxide nanoparticle.

Incidentally, "charge transporting" is synonymous with "electrically conductive," and it refers to the ability to transport holes, electrons, or both charges (holes and electrons). The charge transporting varnish according to the present invention may be capable of transporting charges in itself or may be formed into a solid film capable of transporting charges.

The electron accepting dopant used to improve the charge transportability and other properties of the charge transporting varnish according to the present invention preferably has high electron acceptability. The electron accepting dopant is not specifically restricted in solubility so long as it is soluble in at least one solvent used for the varnish.

For the electron accepting dopant, an inorganic acid, an organic acid, an organic or inorganic oxidizing agent, or the like may be used.

For the organic acid, a polymer organic acid and/or a low molecular organic acid (non-polymeric organic acid) may be used.

In one embodiment, the organic acid is a sulfonic acid, and may also be a salt thereof ($-SO_3M$, wherein M is an alkali-metal ion (e.g., $Na^+$, $Li^+$, $K^+$, $Rb^+$, $Cs^+$, etc.), ammonium ($NH_4^+$), a mono-, di-, and tri- alkylammonium (e.g., triethylammonium)). Among the sulfonic acids, an arylsulfonic acid is preferred.

In some embodiments, examples of electron accepting dopants include, but are not limited to, inorganic strong acids such as hydrogen chloride, sulfuric acid, nitric acid, and phosphoric acid; Lewis acids such as aluminum (III) chloride ($AlCl_3$), titanium (IV) tetrachloride ($TiCl_4$), boron tribromide ($BBr_3$), boron trifluoride ether complex ($BF_3 \cdot OEt_2$), iron (III) chloride ($FeCl_3$), copper (II) chloride ($CuCl_2$), antimony (V) pentachloride ($SbCl_5$), arsenic (V) pentafluoride ($AsF_5$), phosphorus pentafluoride ($PF_5$), and tris(4-bromophenyl)aluminum hexachloroantimonate (TBPAH); polymeric organic acids such as polystyrene sulfonic acid; low molecular weight organic acids (non-polymeric organic acids) such as benzenesulfonic acid, tosylic acid, camphorsulfonic acid, hydroxybenzenesulfonic acid, 5-sulfosalicylic acid, dodecylbenzenesulfonic acid, 1,4-benzodioxanedisulfonic acid derivatives described in WO 2005/000832, arylsulfonic acid derivatives described in WO 2006/025342, dinonylnaphthalenesulfonic acid derivatives described in JP-A-2005-108828; organic or inorganic oxidizing agents such as 7,7,8,8-tetracyanoquinodimethane (TCNQ), 2,3-dichloro-5,6-dicyano-1,4-benzoquinone (DDQ), iodine, heteropoly acid compounds, and the like.

In some embodiments, the electron accepting dopant comprises at least one selected from the group consisting of an arylsulfonic acid compound, a heteropoly acid compound, an ionic compound comprising an element belonging to Group 13 of the long periodic table.

Particularly preferred electron accepting dopants include polymeric organic acids such as polystyrene sulfonic acid, and low molecular organic acids such as 5-sulfosalicylic acid, dodecylbenzenesulfonic acid, 1,4-benzodioxanedisulfonic acid derivatives described in WO 2005/000832, and dinonylnaphthalenesulfonic acid derivatives described in JP 2005-108828. A sulfonic acid derivative represented by the following formula (2) can also be suitably used.

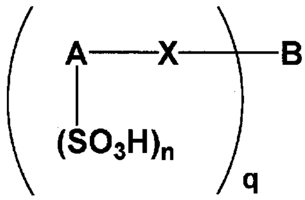

(2)

wherein X represents O, S or NH; A represents a naphthalene or anthracene ring which may have a substituent other than X and the n number of ($SO_3H$) groups; and B represents an unsubstituted or substituted hydrocarbon group, a 1,3,5-triazine group, or an unsubstituted or substituted group represented by formula (3) or (4) below:

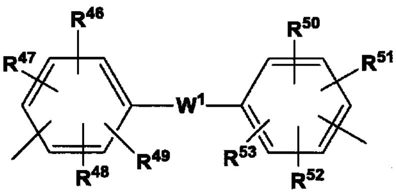

(3)

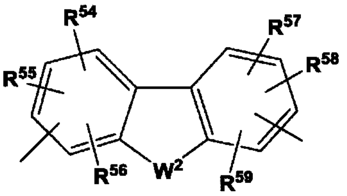

(4)

wherein $W^1$ and $W^2$ each, independently, represent O, S, an S(O) group, an $S(O_2)$ group, or an unsubstituted or substituted N, Si, P, or P(O) group; $W^1$ may also be a single bond; $R^{46}$ to $R^{59}$ each, independently, represent a hydrogen atom or a halogen atom; n represents the number of sulfonic acid groups attached to A and is an integer satisfying $1 \leq n \leq 4$; and q represents the number of bonds between B and X, and is an integer satisfying $1 \leq q$.

$R^{46}$ to $R^{59}$ in formula (3) or (4) are preferably fluorine atoms, and more preferably all fluorine atoms. $W^1$ in formula (3) is preferably a single bond. Most preferably, $W^1$ in formula (3) is a single bond, and $R^{46}$ to $R^{53}$ are all fluorine atoms.

For the arylsulfonic acid compound according to the present invention, a compound represented by the following formula (11) may further be used:

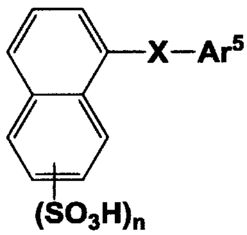

(11)

wherein X represents O, S or NH; $Ar^5$ represents an aryl group; and n represents the number of sulfonic groups and is an integer of 1 to 4.

In formula (11) above, X represents O, S or NH, and particularly preferably is O for ease of synthesis.

n represents the number of sulfonic groups attached to the naphthalene ring and is an integer of 1 to 4, and preferably, n=1 or 2, for the purposes of imparting high electron acceptability and high solubility to the compound. Among them, the compound represented by the following formula (12) is suitable:

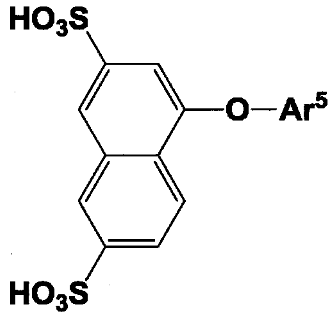

(1 2)

wherein $Ar^5$ represents an aryl group.

Examples of aryl groups in formulae (11) and (12) include such aryl groups as a phenyl group, a xylyl group, a tolyl group, a biphenyl group, and a naphthyl group, and these aryl groups may have a substituent.

Examples of substituents include, but are not limited to, a hydroxyl group, an amino group, a silanol group, a thiol group, a carboxyl group, a phosphoric acid group, a phosphate ester group, an ester group, a thioester group, an amide group, a nitro group, a cyano group, a monovalent hydrocarbon group, an organooxy group, an organoamino group, an organosilyl group, an organothio group, an acyl group, a sulfonic group, a halogen atom, and the like.

Among these aryl groups, an aryl group represented by the following formula (13), in particular, is suitably used:

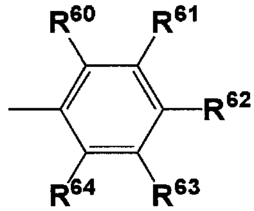

(1 3)

wherein $R^{60}$ to $R^{64}$ each, independently, represent a hydrogen atom, a halogen atom, a nitro group, an alkyl group having 1 to 10 carbon atoms, a halogenated alkyl group having 1 to 10 carbon atoms, and a halogenated alkenyl group having 2 to 10 carbon atoms.

In formula (13), the halogen atom may be any of chlorine, bromine, fluorine, and iodine atoms, but in the present invention, a fluorine atom is particularly suitable.

Examples of alkyl groups having 1 to 10 carbon atoms include methyl, ethyl, n-propyl, i-propyl, n-butyl, i-butyl, t-butyl, n-pentyl, n-hexyl, n-heptyl, n-octyl, n-nonyl, 2-ethylhexyl, n-decyl, cyclopentyl, cyclohexyl, and the like.

Examples of halogenated alkyl groups having 1 to 10 carbon atoms include trifluoromethyl, 2,2,2-trifluoroethyl, 1,1,2,2,2-pentafluoroethyl, 3,3,3-trifluoropropyl, 2,2,3,3,3-pentafluoropropyl, 1,1,2,2,3,3,3-heptafluoropropyl, 4,4,4-trifluorobutyl, 3,3,4,4,4-pentafluorobutyl, 2,2,3,3,4,4,4-heptafluorobutyl, 1,1,2,2,3,3,4,4,4-nonafluorobutyl, and the like.

Examples of halogenated alkenyl groups having 2 to 10 carbon atoms include a perfluorovinyl group, a perfluoropropenyl group (allyl group), and a perfluorobutenyl group.

Among these, for the purposes of further enhancing solubility in organic solvents, it is particularly preferable to use an aryl group represented by the following formula (14):

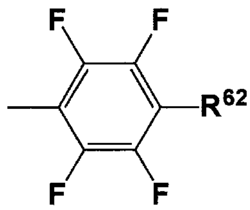

(1 4)

wherein, $R^{62}$ represents a hydrogen atom, a halogen atom, a nitro group, an alkyl group having 1 to 10 carbon atoms, a halogenated alkyl group having 1 to 10 carbon atoms, or a halogenated alkenyl group having 2 to 10 carbon atoms.

In formula (14), $R^{62}$, in particular, is preferably a halogenated alkyl group, a halogenated alkynyl group, or a nitro group, and more preferably a trifluoromethyl group, a perfluoropropenyl group, or a nitro group.

Further, an ionic compound consisting of an anion represented by formula (5a) or $Z^1$ below and a countercation thereof can also be suitably used as an electron accepting dopant.

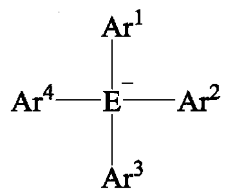

(5a)

wherein E represents an element belonging to Group 13 or 15 of the long periodic table; and $Ar^1$ to $Ar^4$ each, independently, represent an aromatic hydrocarbon group which may have a substituent or an aromatic heterocyclic group which may have a substituent.

In formula (5a), E is preferably boron, gallium, phosphorus, or antimony among the elements belonging to Group 13 or Group 15 of the long period periodic table, and more preferably boron.

Examples of aromatic hydrocarbon groups and aromatic heterocyclic groups in formula (5a) include a monovalent group derived from a 5- or 6-membered single-ring or bicyclo- to tetracyclo- fused-ring system. Among these, a monovalent group derived from a benzene ring, a naphthalene ring, a pyridine ring, a pyrazine ring, a pyridazine ring, a pyrimidine ring, a triazine ring, a quinoline ring, or an isoquinoline ring is preferable from the viewpoint of stability and heat resistance of the compound.

Further, it is more preferable that at least one group among $Ar^1$ to $Ar^4$ has one or more fluorine atoms or chlorine atoms as substituents. In particular, it is most preferable that $Ar^1$ to $Ar^4$ are perfluoroaryl groups in which all the hydrogen atoms are substituted with fluorine atoms. Specific examples of perfluoroaryl groups include a pentafluorophenyl group, a heptafluoro-2-naphthyl group, a tetrafluoro-4-pyridyl group, and the like.

Examples of $Z^1$ include the ions represented by the following formula (5b), and a hydroxide ion, fluoride ion, chloride ion, bromide ion, iodide ion, cyanide ion, nitrate ion, nitrite ion, sulfate ion, sulfite ion, perchlorate ion, perbromate ion, periodate ion, chlorate ion, chlorite ion, hypochlorite ion, phosphate ion, phosphite ion, hypophosphite ion, borate ion, isocyanate ion, hydrosulfide ion, tetrafluoroborate ion, hexafluorophosphate ion, and hexachloroantimonate ion; carboxylate ions such as an acetate ion, trifluoroacetate ion, and benzoate ion; sulfonate ions such as methanesulfonate and trifluoromethanesulfonate ions; and alkoxy ions, such as a methoxy ion, t-butoxy ion, and the like.

$$E^2X_6^- \qquad (5b)$$

wherein $E^2$ represents an element belonging to Group 15 of the long periodic table; and X represents a halogen atom such as a fluorine atom, a chlorine atom, or a bromine atom.

In formula (5b), $E^2$ is preferably a phosphorus atom, an arsenic atom, or an antimony atom, and is preferably a phosphorus atom from the viewpoints of the stabilization, ease of synthesis and purification, and toxicity of the compound.

X is preferably a fluorine atom or a chlorine atom, most preferably a fluorine atom, from the viewpoints of stability and ease of synthesis and purification of the compound.

Among the foregoing, an ionic compound which is the combination of an anion and a cation represented by the following formulae (15), (16), (17), or (18) (see Japanese Patent No. 5381931 (Patent Document 5)) can be suitably used.

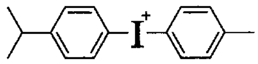
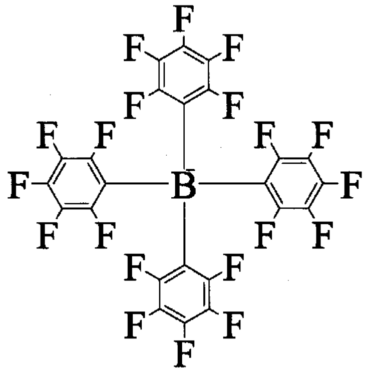
(15)

$Ag^+$
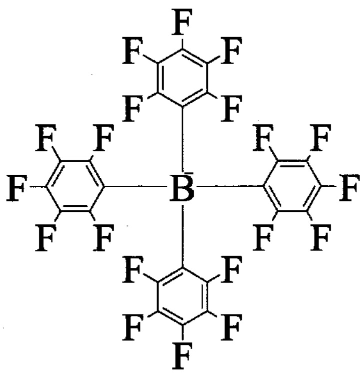
(16)

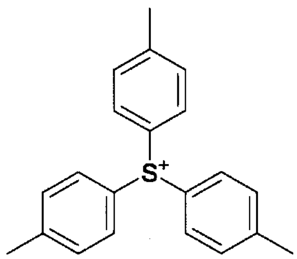
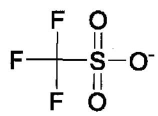
(17)

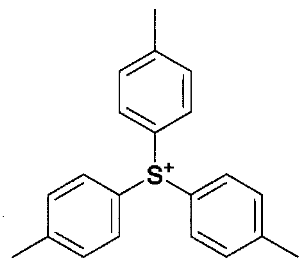
$^-PF_6$
(18)

Heteropoly acid compounds are also particularly preferable as electron accepting dopants. A heteropoly acid compound is a polyacid having a structure in which a heteroatom is located at the center of the molecule, typically represented by a Keggin-type chemical structure shown in formula (A) or a Dawson-type chemical structure shown in formula (B), and is formed by condensation of an isopolyacid, which is an oxoacid of vanadium (V), molybdenum (Mo), tungsten (W), or the like with an oxoacid of a different element. Primary examples of such oxoacids of heterogeneous elements include oxoacids of silicon (Si), phosphorus (P), and arsenic (As).

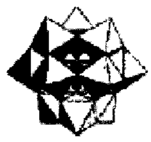 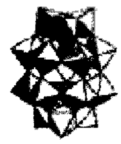

(A) (B)

Specific examples of heteropoly acid compounds include phosphomolybdic acid, silicomolybdic acid, phosphotungstic acid, phosphotungstomolybdic acid, silicotungstic acid, and the like. In consideration of the characteristics of an organic EL device comprising the resulting film, phosphomolybdic acid, phosphotungstic acid and silicotungstic acid are preferable, and phosphotungstic acid is more preferable.

These heteropoly acid compounds may be synthesized by a known synthesis method and used, but are also commercially available. For example, phosphotungstic acid (phosphotungstic acid hydrate or 12-tungstophosphoric acid n-hydrate, chemical formula: $H_3(PW_{12}O_{40})\cdot nH_2O$), and phosphomolybdic acid (phosphomolybdic acid hydrate or 12-molybdo (VI) phosphoric acid n-hydrate, chemical formula: $H_3(PMo_{12}O_{40})\cdot nH_2O$ ($n \approx 30$)) are available from manufacturers such as Kanto Chemical Co., Ltd., Wako Pure Chemical Industries, Ltd., Sigma-Aldrich Japan, Nippon Inorganic Colour & Chemical Co., Ltd., and Japan New Metals Co., Ltd.

The mixing ratio of the electron accepting dopant and the charge transporting material may vary, depending on the molecular structure of the electron accepting dopant, the molecular structure of the charge transporting material, the molecular weight of the electron accepting dopant, the molecular weight of the charge transporting material, and the targeted conductivity of the conductive film. If an organic strong acid having a $SO_3H$ group as described above is used for the electron accepting dopant, a preferable mixing ratio is such that the molar ratio of NH structure in the charge transporting material to $SO_3H$ in the electron accepting dopant is 1:0.01-20, and more preferably $NH:SO_3H$=1:0.05-10 (molar ratio).

In particular, if the oligoaniline compound represented by formula (1) or (1') is combined with a naphthalenedisulfonic acid oligomer (NSO-2) represented by formula (19) below (i.e. a compound disclosed in WO 2006/025342) for the electron accepting dopant, an optimum mixing molar ratio for good transparency (i.e., a decreased amount of host improves transmittance.) and EL characteristics (i.e., the mixing ratio is important as the host has absorption in the visible region and easily causes energy transfer from excitons.) is such that charge transporting material:electron accepting dopant = 1:0.01-10.0, more preferably 1:0.05-4.0.

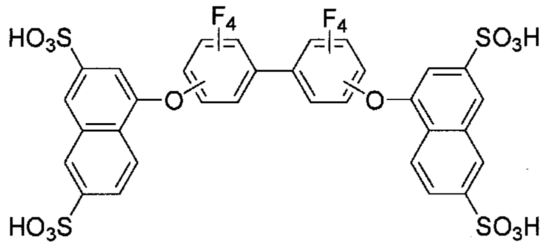

(19)

The charge transporting varnish of the present invention comprises one or more types of metal oxide nanoparticles. It is known that metal oxide nanoparticles can be used for the purposes of improving the optical characteristics of the charge transporting layer of an organic EL element (for example, see Patent Document 3, Patent Document 4, and Non-Patent Document 1), but the application of a metal oxide nanoparticle to a system using an oligoaniline compound as a charge transporting substance has not been known. In particular, the present inventors have found for the first time that the addition of a metal oxide nanoparticle is effective in improving the coloration of the charge transporting film that arises from the use of a colored charge transporting material.

As used herein, "metalloid" refers to an element having chemical and/or physical properties intermediate of, or that are a mixture of, those of metals and nonmetals. Herein, the term "metalloid" refers to boron (B), silicon (Si), germanium (Ge), arsenic (As), antimony (Sb), and tellurium (Te).

As used herein, "metal oxide" refers to an oxide of one or a combination of two or more selected from metals such as tin (Sn), titanium (Ti), aluminum (Al), zirconium (Zr), zinc (Zn), niobium (Nb), tantalum (Ta), and W (tungsten), and the above-mentioned metalloids.

As used herein, the term "nanoparticle" refers to a nanoscale particle, the primary particle average diameter of which is typically 500 nm or less. For the primary particle average diameter, for example, transmission electron microscopy (TEM) or a method of converting from the specific surface area by the BET method can be used.

In the method of measuring particle diameter by TEM, it can be measured by processing a projected image of nanoparticles using image processing software, and then obtaining the area-equivalent diameter (which is defined as

the diameter of a circle having the same area as the nanoparticles). Typically, the processing of projected images is carried out using image processing software that is produced by the TEM manufacturer and distributor and is provided with the TEM (e.g., the transmission electron microscope HT7700, available from Hitachi High Technologies, Inc.). The average particle diameter can be obtained as the number average of circle-equivalent diameters.

The primary particle average diameter of the metal oxide nanoparticles described herein is less than or equal to 500 nm; less than or equal to 250 nm; less than or equal to 100 nm; or less than or equal to 50 nm; or less than or equal to 25 nm. Typically, the metal oxide nanoparticles have a number average particle diameter from about 1 nm to about 100 nm, more typically from about 2 nm to about 30 nm.

Metal oxide nanoparticles suitable for use according to the present disclosure include oxides of boron (B), silicon (Si), germanium (Ge), arsenic (As), antimony (Sb), tellurium (Te), tin (Sn), titanium (Ti), aluminum (Al), zirconium (Zr), zinc (Zn), niobium (Nb), tantalum (Ta), and W (tungsten), etc., or mixed oxides containing these. Non-limiting specific examples of suitable metal oxide nanoparticles include, but are not limited to, nanoparticles comprising $B_2O_3$, $B_2O$, $SiO_2$, SiO, $GeO_2$, GeO, $As_2O_4$, $As_2O_3$, $As_2O_5$, $Sb_2O_3$, $Sb_2O_5$, $TeO_2$, $SnO_2$, $ZrO_2$, $Al_2O_3$, ZnO and mixtures thereof.

In an embodiment, the charge transporting varnish of the present disclosure comprises one or more metal oxide nanoparticles comprising $B_2O_3$, $B_2O$, $SiO_2$, SiO, $GeO_2$, GeO, $As_2O_4$, $As_2O_3$, $As_2O_5$, $SnO_2$, SnO, $Sb_2O_3$, $TeO_2$, or mixtures thereof.

In an embodiment, the charge transporting varnish of the present disclosure comprises one or more metal oxide nanoparticles comprising $SiO_2$.

The metal oxide nanoparticles may comprise one or more organic capping groups. Such organic capping groups may be reactive or non-reactive. Reactive organic capping groups are organic capping groups capable of cross-linking, for example, in the presence of UV radiation or radical initiators.

In an embodiment, the metal oxide nanoparticles comprise one or more organic capping groups.

Examples of suitable metal oxide nanoparticles include $SiO_2$ nanoparticles available as dispersions in various solvents, such as, for example, methanol, methyl ethyl ketone, methyl isobutyl ketone, N,N-dimethylacetamide, ethylene glycol, isopropanol, methanol, ethylene glycol monopropyl ether, cyclohexanone, ethyl acetate, toluene, and propylene glycol monomethyl ether acetate, marketed as ORGANOSILICASOL™ by Nissan Chemical Industries, Ltd.

The amount of the metal oxide nanoparticles used in the charge transporting varnish described herein can be controlled and measured as a weight percentage relative to the combined weight of the metal oxide nanoparticles and the doped or undoped oligoaniline compound represented by formula (1) or formula (1'). In an embodiment, the amount of the metal oxide nanoparticles is from 1 wt. % to 98 wt. %, typically from about 2 wt. to about 95 wt. %, more typically from about 5 wt. % to about 90 wt. %, still more typically about 10 wt. % to about 90 wt. %, relative to the combined weight of the metal oxide nanoparticles and the doped or undoped oligoaniline compound represented by formula (1) or formula (1'). In an embodiment, the amount of the metal oxide nanoparticles is from about 20 wt. % to about 98 wt. %, typically from about 25 wt. to about 95 wt. %, relative to the combined weight of the metal oxide nanoparticles and the doped or undoped oligoaniline compound represented by formula (1) or formula (1').

The charge transporting varnish of the present disclosure may be non-aqueous or may comprise water, but is preferably non-aqueous from the perspective of process compatibility in inkjet coating and the storage stability of the ink. As used herein, "non-aqueous" means that the total amount of water in the charge transporting varnish of the present disclosure is from 0 to 2 wt. %, with respect to the total amount of charge transporting varnish. Typically, the total amount of water in the charge transporting varnish is from 0 to 1 wt. %, more typically from 0 to 0.5 wt. %, with respect to the total amount of charge transporting varnish. In an embodiment, the non-aqueous charge transporting varnish of the present disclosure is substantially free of water.

Examples of the organic solvent used for the charge transporting varnish include, for example, N,N-dimethylformamide (153°C), N,N-dimethylacetamide (165°C), N-methylpyrrolidone (202°C), 1,3-dimethyl-2-imidazolidinone (225°C), dimethylsulfoxide (189°C), N-cyclohexyl-2-pyrrolidinone (284°C), aromatic hydrocarbons [such as benzene (80°C), toluene (111°C), ethylbenzene (136°C), p-xylene (138°C), o-xylene (138°C), and styrene (145°C)], ketones [such as acetone (56°C), methyl ethyl ketone (80°C), methyl isopropyl ketone (94°C), diethyl ketone (102°C), methyl isobutyl ketone (117°C), methyl n-butyl ketone (127°C), cyclohexanone (155°C), and ethyl n-amyl ketone (167°C)], esters [such as ethyl acetate (77°C), isopropyl acetate (85°C), n-propyl acetate (101°C), isobutyl acetate (116°C), n-butyl acetate (125°C), n-amyl acetate (142°C), methyl caproate (151°C), 2-methylpentyl acetate (162°C), and n-butyl lactate (186°C)], glycol esters and glycol ethers [such as ethylene glycol dimethyl ether (85°C), propylene glycol monomethyl ether (119°C), ethylene glycol monomethyl ether (124°C), propylene glycol monoethyl ether (132°C), ethylene glycol monoethyl ether (136°C), ethylene glycol monoisopropyl ether (144°C), ethylene glycol methyl ether acetate (145°C), propylene glycol monomethyl ether acetate (146°C), ethylene glycol ethyl ether acetate (156°C), diethylene glycol dimethyl ether (162°C), propylene glycol monobutyl ether (170°C), ethylene glycol monobutyl ether (171°C), diethylene glycol diethyl ether (188°C), dipropylene glycol monomethyl ether (189°C), diethylene glycol monomethyl ether (194°C), dipropylene glycol monoethyl ether (198°C), diethylene glycol monoethyl ether (202°C), triethylene glycol dimethyl ether (216°C), diethylene glycol monoethyl ether acetate (217°C), and diethylene glycol (244°C)], alcohols [such as methanol (65°C),

ethanol (78°C), isopropanol (82°C), tert-butanol (83°C), allyl alcohol (97°C), n-propanol (97°C), 2-methyl-2-butanol (102°C), isobutanol (108°C), n-butanol (117°C), 2-methyl-1-butanol (130°C), 1-pentanol (137°C), 2-methyl-1-pentanol (148°C), 2-ethyl hexanol (185°C), 1-octanol (196°C), ethylene glycol (197°C), hexylene glycol (198°C), trimethylene glycol (214°C), 1-methoxy-2-butanol (135°C), cyclohexanol (161°C), diacetone alcohol (166°C), furfuryl alcohol (170°C), tetrahydrofurfuryl alcohol (178°C), propylene glycol (187°C), benzyl alcohol (205°C), and 1,3-butanediol (208°C)], phenols [such as phenol (182°C) and m-cresol (202°C)], and ethers, carboxylic acids and derivatives thereof [such as isopropyl ether (68°C), 1,4-dioxane (101°C), anisole (154°C), acetic acid (117°C), and $\gamma$-butyrolactone (204°C)].

These organic solvents may be used alone or in combination with one another.

In the present invention, it is possible to use a high-solvency solvent that readily dissolves the charge transporting substance and the electron accepting dopant. Examples of such high-solvency solvents include N,N-dimethylformamide, N,N-dimethylacetamide, N-methylpyrrolidone, 1,3-dimethyl-2-imidazolidinone, diethylene glycol, dimethylsulfoxide, and dimethyl isobutyramide. These solvents may be used alone or in combination with one another. The amount of these solvents may be 5 to 100 wt. % relative to the amount of all the solvents used for the varnish.

Incidentally, each constituent of the charge transporting vanish is preferably completely dissolved or uniformly dispersed in the solvent above.

Also, the charge transporting varnish of the present invention preferably contains at least one high-viscosity organic solvent having a viscosity at 20°C of 10 to 200 mPa·s, particularly 50 to 150 mPa·s, and a boiling point at normal pressure of 50 to 300°C, particularly 150 to 250°C.

Examples of high-viscosity organic solvents include, for example, cyclohexanol, ethylene glycol, ethylene glycol diglycidyl ether, 1,3-octylene glycol, diethylene glycol, dipropylene glycol, triethylene glycol, tripropylene glycol, 1,3-butanediol, 2,3-butanediol, 1,4-butaneidol, propylene glycol, and hexylene glycol.

The ratio at which the high-viscosity organic solvent is added relative to all the solvents used for the varnish of the present invention is preferably within a range that does not result in solids precipitation. The preferable ratio of addition is 5 to 80 wt. % so long as no solids are precipitated.

In addition, other solvents capable of imparting flatness to the film at the time of baking may be added in a ratio of 1 to 90 wt. %, preferably 1 to 50 wt. %, relative to all the solvents used for the varnish, in order to improve wettability against substrates and control the surface tension, polarity, and boiling point of the solvent.

Examples of such solvents include butyl cellosolve, diethylene glycol dimethyl ether, diethylene glycol diethyl ether, triethylene glycol dimethyl ether, dipropylene glycol monomethyl ether, ethylcarbitol, diacetone alcohol, $\gamma$-butyrolactone, and ethyl lactate.

Specific examples of these solvent combinations, for example, include, but are not limited to, the following.

Examples of combinations of two solvents: 1,3-dimethyl-2-imidazolidinone and cyclohexanol; tetraethylene glycol and diethylene glycol monoethyl ether acetate; dipropylene glycol and diethylene glycol monoethyl ether acetate; triethylene glycol monomethyl ether and diethylene glycol isopropyl ether; diethylene glycol and diethylene glycol monoethyl ether acetate; diethylene glycol and triethylene glycol dimethyl ether; 3-phenoxytoluene and triethylene glycol dimethyl ether; 1,3-dimethyl-2-imidazolidinone and hexylene glycol; 1,3-dimethyl-2-imidazolidinone and diethylene glycol monoethyl ether acetate; N,N-dimethylacetamide and cyclohexanol; N,N-dimethylacetamide and diethylene glycol dimethyl ether; 1,3-dimethyl-2-imidazolidinone and dipropylene glycol monopropyl ether; N,N-dimethylacetamide and n-hexylene acetate; 1,3-dimethyl-2-imidazolidinone and diethylene glycol monoethyl ether acetate; 1,3-dimethyl-2-imidazolidinone and triethylene glycol dimethyl ether; 3-phenoxytoluene and tetralin; diethylene glycol and triethylene glycol dimethyl ether; 3-phenoxytoluene and triethylene glycol dimethyl ether; 1,3-dimethyl-2-imidazolidinone and 2,3-butanediol; and diethylene glycol monomethyl ether and propylene glycol monomethyl ether;

Examples of combinations of three solvents: 1,3-dimethyl-2-imidazolidinone, cyclohexanol and propylene glycol; 1,3-dimethyl-2-imidazolidinone, cyclohexanol and propylene glycol; 1,3-dimethyl-2-imidazolidinone, 2,3-butanediol and diethylene glycol monoethyl ether acetate; 1,3-dimethyl-2-imidazolidinone, cyclohexanol and 2,3-butanediol; 1,3-dimethyl-2-imidazolidinone, cyclohexanol and 2,3-butanediol; 1,3-dimethyl-2-imidazolidinone, 2,3-butanediol and dipropylene glycol monomethyl ether; 1,3-dimethyl-2-imidazolidinone, 2,3-butanediol and propylene glycol monomethylether; 1,3-dimethyl-2-imidazolidinone, triethylene glycol monomethyl ether and hexylene glycol; 1,3-dimethyl-2-imidazolidinone, 2,3-butanediol and dipropylene glycol monomethyl ether; 1,3-dimethyl-2-imidazolidinone, hexylene glycol and dipropylene glycol monomethyl ether; 1,3-dimethyl-2-imidazolidinone, diethylene glycol and diethylene glycol monomethyl ether; tetraethylene glycol, triethylene glycol monomethyl ether, and triethylene glycol dimethyl ether; tetraethylene glycol, triethylene glycol monomethyl ether and diethylene glycol monomethyl ether; diethylene glycol, triethylene glycol monomethyl ether and diethylene glycol monomethyl ether; triethylene glycol monomethyl ether, triethylene glycol dimethyl ether and 3-phenoxybenzyl alcohol; diethylene glycol, triethylene glycol dimethyl ether and 2-benzyloxyethanol; ethylene glycol, triethylene glycol dimethyl ether and 2-benzyloxyethanol; 1,3-dimethyl-2-imidazolidinone, 2-benzyloxyethanol and triethylene glycol dimethyl ether; diethylene glycol, ethylene glycol, triethylene glycol monomethyl ether and 2-benzyloxyethanol; 1,3-dimethyl-2-imidazolidinone, 2,3-butanediol and diethylene glycol monoethyl ether acetate; 1,3-dimethyl-2-imidazolidinone, hexylene glycol and diethylene glycol monoethyl ether acetate; 1,3-dimethyl-2-imidazolidinone, triethylene glycol monomethyl ether and dipropylene glycol monomethyl ether; 1,3-dimethyl-2-imidazolidinone, diethylene glycol monomethyl ether and cyclohexanol; 1,3-dimethyl-2-imidazolidinone, diethylene glycol, 2,3-butanediol and triethylene glycol dimethyl ether; diethylene glycol, triethylene glycol dimethyl ether and 2,3-butanediol; diethylene glycol, dipropylene glycol monomethyl ether and diethylene glycol monomethyl ether; diethylene glycol, dipropylene glycol monomethyl ether and 1,3-dimethyl-2-imidazolidinone; diethylene glycol, 2-benzyloxyethanol and dipropylene glycol monomethyl ether; 1,3-dimethyl-2-imidazolidinone, diethylene glycol and triethylene glycol monomethyl ether; 1,3-dimethyl-2-imidazolidinone, diethylene glycol and triethylene glycol monomethyl ether; 1,3-dimethyl-2-imidazolidinone, diethylene glycol and dipropylene glycol monomethyl ether; 1,3-dimethyl-2-imidazolidinone, dipropylene glycol and tripropylene glycol monomethyl ether; N,N-dimethylacetamide, cyclohexanol and diethylene glycol dimethyl ether; 1,3-dimethyl-2-imidazolidinone, dipropylene glycol monopropyl ether and diethylene glycol monoethyl ether acetate; 1,3-dimethyl-2-imidazolidinone, dipropylene glycol and dipropylene glycol monomethyl ether; 1,3-dimethyl-2-imidazolidinone, 2,3-butanediol and diethylene glycol monoethyl ether acetate; 1,3-dimethyl-2-imidazolidinone, 2-phenoxyethanol and 2,3-butanediol; 1,3-dimethyl-2-imidazolidinone, 1,3-butanediol and diethylene glycol monoethyl ether acetate; 1,3-dimethyl-2-imidazolidinone, methyl benzoate and 1,3-butanediol; 1,3-dimethyl-2-imidazolidinone, tetraethylene glycol and triethylene glycol monomethyl ether; 1,3-dimethyl-2-imidazolidinone, hexylene glycol and dipropylene glycol; 1,3-dimethyl-2-imidazolidinone, diethylene glycol monomethyl ether and diethylene glycol; 1,3-dimethyl-2-imidazolidinone, hexylene glycol and triethylene glycol dimethyl ether; 1,3-dimethyl-2-imidazolidinone, cyclohexanol, and diethylene glycol monoethyl ether acetate; 1,3-dimethyl-2-imidazolidinone, cyclohexanol, and diethylene glycol monobutyl ether acetate; tetraethylene glycol, triethylene glycol monomethyl ether and hexylene glycol; tetraethylene glycol, triethylene glycol monomethyl ether and diethylene glycol monoethyl ether acetate; dipropylene glycol, diethylene glycol monoethyl ether acetate and 1,3-dimethyl-2-imidazolidinone; 1,3-dimethyl-2-imidazolidinone, dipropylene glycol, and diethylene glycol monoethyl ether acetate; 1,3-dimethyl-2-imidazolidinone, triethylene glycol dimethyl ether and diethylene glycol; 1,3-dimethyl-2-imidazolidinone, 2,3-butanediol, and dipropylene glycol monomethyl ether; 1,3-dimethyl-2-imidazolidinone, 2,3-butanediol and dipropylene glycol monomethyl ether; and 1,3-dimethyl-2-imidazolidinone, diethylene glycol monomethyl ether and propylene glycol monomethyl ether; and

Examples of combinations of four solvents: diethylene glycol, triethylene glycol monomethyl ether, diethylene glycol monomethyl ether and dipropylene glycol monomethyl ether; diethylene glycol, triethylene glycol monomethyl ether, diethylene glycol monomethyl ether and diethylene glycol isopropyl ether; 1,3-dimethyl-2-imidazolidinone, triethylene glycol monomethyl ether, 2,3-butanediol, and diethylene glycol monoethyl ether acetate; 1,3-dimethyl-2-imidazolidinone, diethylene glycol, diethylene glycol monophenyl ether, and diethylene glycol monomethyl ether; 1,3-dimethyl-2-imidazolidinone, tetraethylene glycol, triethylene glycol monomethyl ether and 3-phenoxybenzyl alcohol; 1,3-dimethyl-2-imidazolidinone, hexylene glycol, 2,3-butanediol and tetrahydrofuryl alcohol; and 1,3-dimethyl-2-imidazolidinone, 2-phenoxyethanol, diethylene glycol monoethyl ether acetate and 2,3-butanediol.

In an embodiment, organic solvents used in the charge transporting varnish according to the present invention include ethers such as anisole, ethoxybenzene, dimethoxy benzenes and glycol diethers (glycol diethers), such as, ethylene glycol diethers (such as 1,2-dimethoxyethane, 1,2-diethoxyethane, and 1,2-dibutoxyethane); diethylene glycol diethers such as diethylene glycol dimethyl ether, and diethylene glycol diethyl ether; propylene glycol diethers such as propylene glycol dimethyl ether, propylene glycol diethyl ether, and propylene glycol dibutyl ether; dipropylene glycol diethers, such as dipropylene glycol dimethyl ether, dipropylene glycol diethyl ether, and dipropylene glycol dibutyl ether; as well as higher analogues (i.e., tri- and tetra-analogues, e.g., triethylene glycol dimethyl ether, triethylene glycol butyl methyl ether, tetraethylene glycol dimethyl ether, etc.) of the ethylene glycol and propylene glycol ethers mentioned herein.

Still other solvents can be considered, such as ethylene glycol monoether acetates and propylene glycol monoether acetates (glycol ester ethers), wherein the ether can be selected, for example, from methyl, ethyl, n-propyl, isopropyl, n-butyl, sec-butyl, tert-butyl, and cyclohexyl; as well as higher glycol ether analogues of the above list (such as di-, tri- and tetra-).

Examples include, but are not limited to, propylene glycol methyl ether acetate, 2-ethoxyethyl acetate, 2-butoxyethyl acetate, ethylene glycol monomethyl ether acetate, diethylene glycol monomethyl ether acetate.

Still other solvents such as ethylene glycol diacetate (glycol diesters) can be considered, which include higher glycol ether analogues (such as di-, tri- and tetra-).

Examples include, but are not limited to, ethylene glycol diacetate, triethylene glycol diacetate, propylene glycol diacetate.

Alcohols may also be considered for use in the charge transporting varnish, such as, for example, methanol, ethanol, trifluoroethanol, n-propanol, isopropanol, n-butanol, t-butanol, and and alkylene glycol monoethers (glycol monoethers). Examples of suitable glycol monoethers include, but are not limited to, ethylene glycol monopropyl ether, ethylene glycol monohexyl ether (hexyl Cellosolve), propylene glycol monobutyl ether (Dowanol PnB), diethylene glycol monoethyl ether (ethyl Carbitol), dipropylene glycol n-butyl ether (Dowanol DPnB), ethylene glycol monobutyl ether (butyl Cellosolve), diethylene glycol monobutyl ether (butyl Carbitol), dipropylene glycol monomethyl ether (Dowanol DPM), diisobutyl carbinol, 2-ethylhexyl alcohol, methyl isobutyl carbinol, propylene glycol monopropyl ether (Dowanol

PnP), diethylene glycol monopropyl ether (propyl Carbitol), diethylene glycol monohexyl ether (hexyl Carbitol), 2-ethylhexyl carbitol, dipropylene glycol monopropyl ether (Dowanol DPnP), tripropylene glycol monomethyl ether (Dowanol TPM), diethylene glycol monomethyl ether (methyl Carbitol), and tripropylene glycol monobutyl ether (Dowanol TPnB).

As disclosed herein, the organic solvents disclosed herein can be used in varying proportions in the charge transporting varnish, for example, to improve the ink characteristics such as substrate wettability, ease of solvent removal, viscosity, surface tension, and jettability.

In an embodiment, the charge transporting varnish comprises dimethyl sulfoxide, ethylene glycol (glycols), tetramethyl urea, or a mixture thereof.

Examples of suitable glycols include, but are not limited to, ethylene glycol, diethylene glycol, dipropylene glycol, polypropylene glycol, propylene glycol, triethylene glycol, and the like.

The above-mentioned glycol diethers, glycol ester ethers, glycol diesters, glycol monoethers, glycol monoethers, glycols, and the like are collectively referred to as "glycol-based solvents". That is, a "glycol-based solvent" as used herein is an organic solvent that does not have one or more aromatic structures, represented by the formula $R^1$-O-(R-O)$_n$-$R^2$, wherein each R is, independently, a linear $C_2$-$C_4$ unsubstituted alkylene group, and $R^1$ and $R^2$ are each, independently, a hydrogen atom, a linear, branched, or cyclic $C_1$-$C_8$ unsubstituted alkyl group, or a linear or branched $C_1$-$C_8$ unsubstituted aliphatic acyl group, and n is an integer of 1 to 6. It is particularly preferable that R is a $C_2$ or a $C_3$ unsubstituted alkylene group. As the alkyl group, a linear, branched or cyclic $C_1$-$C_6$ unsubstituted alkyl group is preferable, a linear $C_1$-$C_4$ unsubstituted alkyl group is more preferable, and a methyl group and an n-butyl group are particularly preferable. As the acyl group, a linear or branched $C_2$-$C_6$ unsubstituted aliphatic acyl group is preferable, a linear $C_2$-$C_4$ unsubstituted acyl group is more preferable, and an acetyl group and a propionyl group are particularly preferable. It is particularly preferable that n is an integer of 1 to 4. Such glycol-based solvents include, for example, the following solvents.

- Glycols which are ethylene glycol, propylene glycol or oligomers thereof (dimers to tetramers, e.g. diethylene glycol)
- Glycol monoethers which are monoalkyl ethers of the aforementioned glycols
- Glycol diethers which are dialkyl ethers of the aforementioned glycols
- Glycol monoesters which are aliphatic carboxylic acid monoesters of the aforementioned glycols
- Glycol diesters which are aliphatic carboxylic acid diesters of the aforementioned glycols
- Glycol ester ethers which are aliphatic carboxylic acid monoesters of the aforementioned glycol monoethers

For ease of application by inkjet coating, it is preferable to use a liquid carrier comprising a glycol-based solvent.

In the following description, glycol-based solvents may be contrasted with organic solvents not falling under this category, and, for convenience, the former may be denoted by (A) and the latter may be denoted by (B).

In an embodiment, the charge transporting varnish is a charge transporting varnish comprising one or more glycol-based solvents (A).

In an embodiment, the charge transporting varnish is a charge transporting varnish comprising one or more glycol-based solvents (A) and one or more organic solvents other than glycol-based solvents (B).

Preferable examples of glycol-based solvents (A) include glycol diethers, glycol monoethers, and glycols, as well as mixtures thereof.

Examples include, but are not limited to, mixtures of glycol diethers and glycols.

Specific examples include the above-mentioned glycol diethers and glycols, but preferable examples of glycol diethers include triethylene glycol dimethyl ether and triethylene glycol butyl methyl ether, and preferable examples of glycols include ethylene glycol and diethylene glycol.

Preferable examples of organic solvents (B) include nitriles, alcohols, aromatic ethers, and aromatic hydrocarbons.

Examples of nitriles include, but are not limited to, methoxypropionitrile and ethoxypropionitrile. Examples of alcohols include, but are not limited to, benzyl alcohol, and 2-(benzyloxy)ethanol. Examples of aromatic ethers include, but are not limited to, methyl anisole, dimethyl anisole, ethyl anisole, butyl phenyl ether, butyl anisole, pentyl anisole, hexyl anisole, heptyl anisole, octyl anisole, phenoxy toluene. Examples of aromatic hydrocarbons include, but are not limited to, pentylbenzene, hexylbenzene, heptylbenzene, octylbenzene, nonylbenzene, cyclohexylbenzene, and tetralin.

Among these, alcohols are more preferable, and 2-(benzyloxy)ethanol is more preferable among the alcohols.

Addition of an organic solvent (B) to a glycol-based solvent (A) allows proper control, at the time of film formation by ink-jet coating, of the aggregation of the metal oxide nanoparticles while maintaining the solubility of the solids in the ink, thereby enabling a flatter film to be formed.

When the organic solvent (B) is added to the glycol-based solvent (A), the amount of glycol-based solvent (A): wtA (in weight) and the amount of organic solvent (B): wtB (in weight) preferably satisfy formula (1-1), more preferably satisfy formula (1-2), and most preferably satisfy formula (1-3).

$$0.05 \leq wtB / (wtA + wtB) \leq 0.50 \qquad (1\text{-}1)$$

$$0.10 \leq wtB / (wtA + wtB) \leq 0.40 \qquad (1\text{-}2)$$

$$0.15 \leq wtB / (wtA + wtB) \leq 0.30 \qquad (1\text{-}3)$$

Where the composition of the present invention comprises two or more glycol-based solvents (A), wtA indicates the total amount (in weight) of glycol-based solvents (A); where the composition of the present invention comprises two or more organic solvents (B), wtB indicates the total amount (in weight) of organic solvents (B).

The amount of solids in the charge transporting varnish is preferably 0.001 to 50 wt. %, more preferably 0.01 to 20 wt. %, in consideration of the workability at the time of application of the varnish.

The charge transporting varnish described above can be made into a charge transporting film on a substrate as it is applied to a substrate and its solvent is evaporated.

The method for varnish application is not specifically restricted, and examples include dipping, spin coating, transfer printing, roll coating, brushing, inkjet coating, and spraying.

The method for solvent evaporation is not specifically restricted, and examples include heating with a hot plate or oven in an adequate atmosphere (i.e. under air or an inert gas like nitrogen, or in a vacuum, etc.). In this way a film with a uniform surface can be obtained.

The baking temperature is not specifically restricted so long as it allows the solvent to evaporate, but is preferably 40 to 250°C. Baking may be accomplished in two or more stages at different temperatures for even higher film uniformity or in order to cause reactions to proceed on the substrate.

The charge transporting film is not specifically restricted in thickness. If it is used as the charge injection layer in an organic EL device, its preferred thickness is 5 to 200 nm. The thickness may be changed by adjusting the concentration of solids in the varnish or the amount of solution on the substrate at the time of application.

The charge transporting film obtained as described above contains metal oxide nanoparticles, and this results in an improved average transmittance (%) over the wavelength range of 400 to 800 nm. As used herein, "improved" means that the average transmittance for a charge transporting film comprising metal oxide nanoparticles is greater than that for a corresponding charge transporting film without metal oxide nanoparticles. The improvement in the average transmittance of the former over the latter is typically 1% or more, preferably 3% or more, and more preferably 5% or more.

As a result, the charge transporting film of the present invention has a high light transmittance in the visible region and shows less coloration than conventional ones, despite the fact that an oligoaniline compound, a colored material, is used as the charge transporting material. For the charge transporting film of the present invention, the average transmittance over the wavelength range of 400 to 800 nm when the film is formed on a quartz substrate at a thickness of 50 nm is typically 90% or more, preferably 95% or more.

The charge transporting varnish of the present invention can be used for the manufacture of either an organic EL device that uses a low molecular light-emitting material (hereinafter referred to as "OLED") or an organic EL device that uses a high molecular light-emitting material (hereinafter referred to as "PLED").

Examples of materials and methods used in the production of an OLED device using the charge transporting varnish of the present invention include, but are not limited to the following.

The electrode substrate to be used should preferably be cleaned beforehand by washing with a liquid such as a detergent, alcohol, and pure water. For example, an anode substrate should preferably undergo surface treatment such as ozone treatment and oxygen-plasma treatment immediately before use. This surface treatment may be omitted if the anode material is composed mainly of organic materials.

The following method may be employed to use a hole transporting varnish in an OLED device.

The hole transporting varnish is applied to the anode substrate. This step is followed by solvent evaporation and baking in the way described above, thereby obtaining a hole transporting film formed on the electrode. The electrode is placed in a vacuum evaporation apparatus for sequential deposition thereon with a hole transport layer, light-emitting layer, electron transport layer, electron injection layer, and cathode metal to obtain an OLED device as desired. A carrier blocking layer may optionally be interposed between any layers to control the light-emitting region.

The anode material may be formed from a transparent electrode material such as indium tin oxide (ITO) and indium zinc oxide (IZO). It is preferably planarized. It is also possible to use a polythiophene derivative or a polyaniline derivative having high charge transportability.

Examples of materials used to form the hole transport layer include triarylamines, such as (triphenylamine)dimer derivative (TPD), (a-naphthyldiphenylamine)dimer ($\alpha$-NPD), and [(triphenylamine)dimer]spirodimer (Spiro-TAD); star-burst amines, such as 4,4',4"-tris(3-methylphenyl(phenyl)amino)triphenylamine (m-MTDATA), 4,4',4"-tris[1-naphthyl(phenyl)amino]triphenylamine (1-TNATA); and oligothiophenes, such as 5,5"-bis-{4-[bis(4-methylphenyl)amino]phenyl}-2,2':5',2"-terthiophene (BMA-3T).

Examples of materials used to form the light-emitting layer include tris(8-quinolinolate)aluminum (III) ($Alq_3$), bis(8-quinolinolate)zinc (II) ($Znq_2$), bis(2-methyl-8-quinolinolate)(p-phenylphenolate)aluminum (III) (BAlq), and 4,4'-bis(2,2-diphenylvinyl)biphenyl (DPVBi). The light-emitting layer may be formed by vapor codeposition of an electron transporting material or a hole transporting material together with a light-emitting dopant.

Examples of electron transporting materials include $Alq_3$, BAlq, DPVBi, (2-(4-biphenyl)-5-(4-t-butylphenyl)-1,3,4-oxadiazole) (PBD), triazole derivatives (TAZ), bathocuproine (BCP), and silole derivatives.

Examples of light-emitting dopants include quinacridone, rubrene, coumarin 540, 4-(dicyanomethylene)-2-methyl-6-(p-dimethylaminostylyl)-4H-pyran (DCM), tris(2-phenylpyridine)iridium (III) ($Ir(ppy)_3$), (1,10-phenanthroline)-tris(4,4,4-trifluoro-1-(2-thienyl)-butane-1,3-dionate)europium (III) ($Eu(TTA)_3phen$), and the like.

Examples of materials used to form the carrier blocking layer include PBD, TAZ, BCP, and the like.

Examples of materials used to form the electron injection layer include lithium oxide ($Li_2O$), magnesium oxide (MgO), alumina ($Al_2O_3$), lithium fluoride (LiF), magnesium fluoride ($MgF_2$), strontium fluoride ($SrF_2$), Liq, Li(acac), lithium acetate, lithium benzoate, and the like.

Examples of materials used to form the cathode include aluminum, magnesium-silver alloys, aluminum-lithium alloys, lithium, sodium, potassium, cesium, and the like.

Methods for producing a PLED device using the charge transporting varnish of the present invention is not particularly restricted but include the following exemplary method.

A PLED device containing a charge transporting film (hole injection layer) formed from the charge transporting varnish of the present invention can be produced by forming a light-emitting charge transporting polymer layer instead of performing vacuum deposition to form the hole transport layer, light-emitting layer, electron transport layer, and electron injection layer in the production of an OLED device described above.

Specifically, the PLED device is produced by coating the anode substrate with the charge transporting varnish (hole transporting varnish), thereby forming a hole transporting film as described above, and covering it with a light-emitting charge transporting polymer layer and forming a cathode electrode by vapor deposition.

The cathode may be formed from the same materials as used for the production of an OLED device described above. They may undergo cleaning and surface treatment in the same way as described above.

The light-emitting charge transporting polymer layer may be formed by dissolving or uniformly dispersing a light-emitting charge transporting polymer material (alone or together with a light-emitting dopant) in a solvent, applying the resulting solution or dispersion onto an electrode substrate on which a hole injection layer has been formed, and finally evaporating the solvent.

Examples of light-emitting charge transporting polymer materials include, for example, polyfluorene derivatives such as poly(9,9-dialkylfluorene) (PDAF), polyphenylenevinylene derivatives such as poly(2-methoxy-5-(2'-ethylhexoxy)-1,4-phenylenevinylene) (MEH-PPV), polythiophene derivatives such as poly(3-alkylthiophene) (PAT), and polyvinylcarbazole (PVCz).

Examples of solvents include toluene, xylene, chloroform, and the like. Dissolution or uniform dispersion may be accomplished by stirring with or without heating or by ultrasonic dispersion.

Methods for application are not specifically restricted; they include inkjet coating, spraying, dipping, spin coating, transfer printing, roll coating, and brushing. Application should preferably be carried out under an inert gas such as nitrogen and argon.

Solvent evaporation may be accomplished by heating with an oven or hot plate under an inert gas or in a vacuum.

## Examples

Hereinafter, the present invention will be described more specifically with reference to manufacturing examples and examples, but the present invention is not limited to the examples described below. The apparatus used was as follows.

(1) Substrate Cleaning: Substrate cleaning equipment (reduced-pressure plasma system), manufactured by Choshu Industry Co., Ltd.
(2) Varnish coating: MS-A100 spin coater, manufactured by Mikasa Co., Ltd.
(3) Film thickness measurement: Microfigure measuring instrument surfcorder ET-4000, manufactured by Kosaka Laboratory, Ltd.
(4) EL device fabrication: C-E2L1G1-N multifunction evaporation system, manufactured by Choshu Industry Co., Ltd.
(5) Measurement of EL device luminance etc.: Multi-channel IVL measuring system, manufactured by EHC Co., Ltd.
(6) Measurement of EL device lifetime (half-life measurement): PEL-105S organic EL luminance lifetime evaluation

system, manufactured by EHC Co., Ltd.
(7) Measurement of transmittance: UV-3600 ultraviolet-visible-near-infrared spectrophotometer from Shimadzu Science.

**(1) Varnish preparation**

**Example 1-1**

First, under a nitrogen atmosphere, 0.060 g of the aniline derivative represented by formula (A1) synthesized according to the method described in WO 2013/084664 and 0.120 g of the arylsulfonic acid represented by formula (S1) synthesized according to the method described in WO 2006/025342 were dissolved in 5.8 g of 1,3-dimethyl-2-imidazolidinone. To this was added 7.8 g of 2,3-butanediol and 4.2 g of dipropylene glycol monomethyl ether, followed by stirring, after which 2.029 g of a silica sol dispersed in ethylene glycol (EG-ST, manufactured by Nissan Chemical Industries, Ltd., particle size: 10 nm-15 nm, $SiO_2$: 20.5 wt. %) was added and stirred to obtain a varnish for forming a hole injection layer.

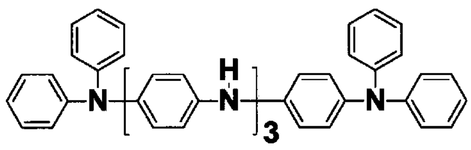

(A1)

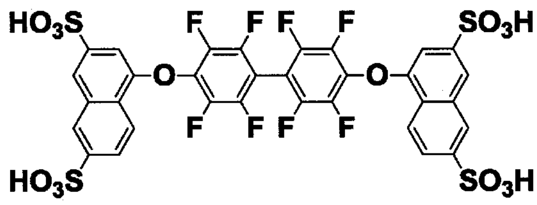

(S1)

**Comparative Example 1-1**

In the same manner as in Example 1-1, 0.312 g of the aniline derivative represented by formula (A1) and 0.616 g of the arylsulfonic acid represented by formula (S1) were dissolved in 9.0 g of 1,3-dimethyl-2-imidazolidinone. To the mixture, 12.0 g of 2,3-butanediol and 9.0 g of dipropylene glycol monomethyl ether were added and stirred to obtain a varnish for forming a hole injecting layer.

**(2) Evaluation of transmittance**

**Example 2-1**

The varnish obtained in Example 1-1 was applied to a quartz substrate using a spin coater, and then dried by baking in an air atmosphere at 80°C for 1 minute. Next, the dried quartz substrate was baked at 230°C for 15 minutes in an air atmosphere to form a uniform film of 50 nm thickness on the quartz substrate.

**Comparative Example 2-1**

A uniform film of 50 nm thickness was formed on a quartz substrate using the varnish obtained in Comparative Example 1-1 in the same manner as in Example 2-1.
Light transmittance was measured with a spectrophotometer by using the quartz substrates obtained in Example 2-1 and Comparative Example 2-1. The results are shown in FIG. 1 and Table 1.

Table 1

| | Average transmittance (%) from 400 nm to 800 nm |
|---|---|
| Example 2-1 | 96.5 |
| Comparative example 2-1 | 89.6 |

As shown in FIG. 1 and Table 1, the addition of ORGANOSILICASOL improved average light transmittance in the visible region.

### (3) Fabrication and characterization of organic EL devices

**Example 3-1**

The varnish obtained in Example 1-1 was applied to an ITO substrate using a spin coater, and was subsequently dried at 80°C under air atmosphere for 1 minute. Subsequently, the dried substrate was baked at 230°C for 15 minutes under air atmosphere to form a uniform film, 50 nm thick, on the ITO substrates. For the ITO substrate, a glass substrate (25 mm × 25 mm × 0.7 t) on the surface of which a patterned indium tin oxide (ITO) film having a thickness of 150 nm was formed was used, and the impurities on the surface of the glass substrate were removed by an $O_2$ plasma cleaning device (150 W, 30 seconds) prior to use.

Next, α-NPD (N,N'-di(1-naphthyl)-N,N'-diphenylbenzidine) was deposited using an vacuum evaporator (degree of vacuum: $1.0 \times 10^{-5}$ Pa) to a thickness of 120 nm at a rate of 0.2 nm/sec on the ITO substrate on which the film was formed. Next, another film of HTEB-01 (an electron blocking material manufactured by Kanto Chemical Co., Ltd.) was formed having a thickness of 10 nm. Then, NS60 (a host material for the light emitting layer manufactured by Nippon Steel & Sumikin Chemical Co., Ltd.) and $Ir(PPy)_3$ (a dopant material for the light emitting layer) were co-deposited. In this co-deposition process, the deposition rate was controlled so that the concentration of $Ir(PPy)_3$ was 6%, and the layer was deposited to a thickness of 40 nm. Next, films of $Alq_3$, lithium fluoride and aluminum were successively laminated to obtain an organic electroluminescent device. In these steps, the deposition rates were set to 0.2 nm/sec for $Alq_3$, 0.2 nm/sec for aluminum, and 0.02 nm/sec for lithium fluoride and the film thicknesses were set to 20 nm, 0.5 nm, and 80 nm, respectively.

In order to prevent characteristic deterioration under the influence of oxygen, water, and the like in the air, the organic EL device was sealed using sealing substrates before the characteristics thereof were evaluated. Sealing was performed by the following procedure. The organic EL device was placed between sealing substrates in a nitrogen atmosphere having an oxygen concentration of 2 ppm or less and a dew point of -76°C or less, and the sealing substrates were bonded to each other using an adhesive (Moresco Moisture Cut WB90US (P), manufactured by MORESCO Corporation). In this step, a water-trapping agent (HD-071010W-40, manufactured by Dynic Corporation) was placed between the sealing substrates together with the organic EL device, and the sealing substrates stuck together were irradiated with UV light (wavelength: 365 nm, irradiation level: 6,000 mJ/cm²), and then annealed at 80°C for 1 hour to cure the adhesive.

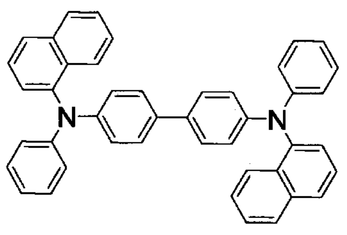

NPB

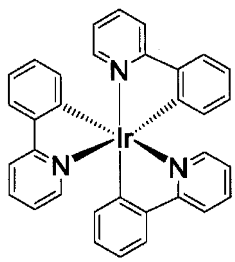

$Ir(PPy)_3$

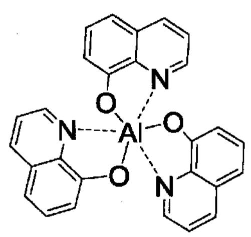

$Alq_3$

**Comparative Example 3-1**

The procedure of Example 3-1 was repeated except that the varnish obtained in Comparative Example 1-1 was used instead of the varnish obtained in Example 1-1.

The devices of Example 3-1 and Comparative Example 3-1 were each driven at a luminance of 10,000 cd/m², and the drive voltage, current density, and luminous efficacy, and luminance half-life (time elapsed before luminance from an initial value of 10,000 cd/m² reaches half the initial value) were measured. The results are shown in Table 2.

Table 2

| | Drive voltage (V) | Current density (mA/cm²) | Current efficiency (cd/A) | Luminance half-life (h) | External quantum efficiency (%) |
|---|---|---|---|---|---|
| Example 3-1 | 7.2 | 21.1 | 47.4 | 503 | 13.4 |

(continued)

| | Drive voltage (V) | Current density ($mA/cm^2$) | Current efficiency (cd/A) | Luminance half-life (h) | External quantum efficiency (%) |
|---|---|---|---|---|---|
| Comparative Example 3-1 | 6.8 | 23.1 | 43.3 | 435 | 12.1 |

As shown in Table 2, the EL device comprising the charge transporting film of the present invention exhibited an improved current efficiency, due to the addition of ORGANOSILICASOL. It was also excellent in lifetime performance.

**(1) Varnish preparation**

**Example 1-2**

First, under a nitrogen atmosphere, 0.050 g of the aniline derivative represented by formula (A1) synthesized according to the method described in WO 2013/084664 and 0.250 g of phosphotungstic acid were dissolved in 5.7 g of 1,3-dimethyl-2-imidazolidinone. To this was added 7.6 g of 2,3-butanediol and 4.165 g of dipropylene glycol monomethyl ether, followed by stirring, after which 2.295 g of a silica sol dispersed in triethylene glycol dimethyl ether was added and stirred to obtain a varnish for forming a hole injection layer.

**Method for preparing the silica sol dispersed in triethylene glycol dimethyl ether**

A 500 ml eggplant-shaped flask 250 g was charged with a silica sol dispersed in MEK (MEK-ST, manufactured by Nissan Chemical Industries, Ltd., particle size: 10-15 nm, $SiO_2$: 30 wt. %) and 170 g of triethylene glycol dimethyl ether, and was set in a rotary evaporator. The mixture was concentrated in vacuo to a weight of 250 g to obtain a silica sol dispersed in triethylene glycol dimethyl ether ($SiO_2$: 30 wt. %).

**Comparative Example 1-2**

In the same manner as in Example 1-2, 0.175 g of the aniline derivative represented by formula (A1) and 0.877 g of phosphotungstic acid were dissolved in 6.0 g of 1,3-dimethyl-2-imidazolidinone. To the mixture, 8.0 g of 2,3-butanediol and 6.0 g of dipropylene glycol monomethyl ether were added and stirred to obtain a varnish for forming a hole injecting layer.

**(2) Evaluation of transmittance**

**Example 2-2**

A uniform film of 50 nm thickness was formed on a quartz substrate using the varnish obtained in Example 1-2, in the same manner as in Example 2-1.

**Comparative Example 2-2**

A uniform film of 50 nm thickness was formed on a quartz substrate using the varnish obtained in Comparative Example 1-2 in the same manner as in Example 2-1.

Light transmittance was measured with a spectrophotometer by using the quartz substrates obtained in Example 2-2 and Comparative Example 2-2. The results are shown in FIG. 2 and Table 3.

Table 3

| | Average transmittance (%) from 400 nm to 800 nm |
|---|---|
| Example 2-2 | 96.8 |
| Comparative example 2-2 | 75.4 |

As shown in FIG. 2 and Table 3, the addition of ORGANOSILICASOL improved average light transmittance in

the visible region.

**(3) Fabrication and characterization of organic EL devices**

**Example 3-2**

The procedure of Example 3-1 was repeated except that the varnish obtained in Example 1-2 was used instead of the varnish obtained in Example 1-1 and that the thickness of the α-NPD was changed to 30 nm.

**Comparative Example 3-2**

The procedure of Example 3-2 was repeated except that the varnish obtained in Comparative Example 1-2 was used instead of the varnish obtained in Example 1-2.

The devices of Example 3-2 and Comparative Example 3-2 were each driven at a luminance of 10,000 $cd/m^2$, and the drive voltage, current density, and luminous efficacy, and luminance half-life (time elapsed before luminance from an initial value of 10,000 $cd/m^2$ reaches half the initial value) were measured. The results are shown in Table 4.

Table 4

| | Drive voltage (V) | Current density ($mA/cm^2$) | Current efficiency (cd/A) | Luminance half-life (h) | External quantum efficiency (%) |
|---|---|---|---|---|---|
| Example 3-2 | 5.9 | 19.2 | 52.1 | 634 | 14.9 |
| Comparative Example 3-2 | 6.0 | 23.1 | 43.4 | 431 | 12.5 |

As shown in Table 4, the EL device comprising the charge transporting film of the present invention exhibited an improved current efficiency, due to the addition of ORGANOSILICASOL. It was also excellent in lifetime performance.

**Claims**

1. A charge transporting varnish comprising an oligoaniline compound, an electron accepting dopant, a metal oxide nanoparticle, and an organic solvent.

2. The charge transporting varnish according to claim 1, wherein the oligoaniline compound is at least one selected from the oligoaniline compounds represented by formula (1) and formula (1').

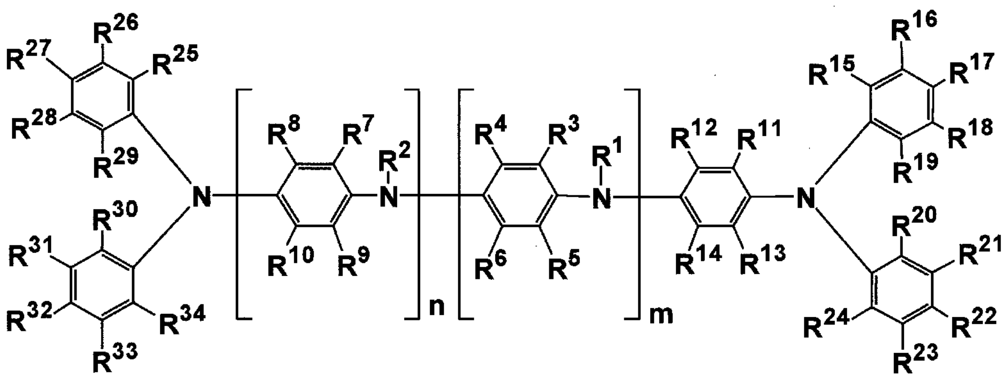

(1)

wherein

$R^1$ and $R^2$ each, independently, represent a hydrogen atom, a substituted or unsubstituted monovalent hydrocarbon group, a t-butoxycarbonyl group, or a benzyloxycarbonyl group;
$R^3$ to $R^{34}$ each, independently, represent a hydrogen atom, a hydroxyl group, a silanol group, a thiol group, a

carboxyl group, a phosphoric acid group, a phosphate ester group, an ester group, a thioester group, an amide group, a nitro group, a substituted or unsubstituted monovalent hydrocarbon group, an organoxy group, an organoamino group, an organosilyl group, an organothio group, an acyl group, a sulfonic group or a halogen atom; and

m and n each, independently, represent an integer of 1 or more and satisfy m + n ≤ 20;

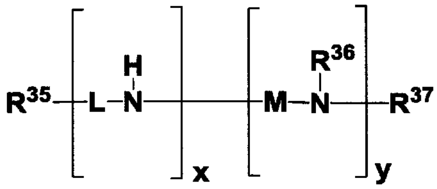

(1′)

wherein

R^35^, R^36^, and R^37^ each, independently, represent a hydrogen atom, an unsubstituted or substituted monovalent hydrocarbon group, or an organooxy group;

L and M each, independently, represent a divalent group represented by general formula (6) or (7);

$R^{38}$ to $R^{45}$ each, independently, represent a hydrogen atom, a hydroxyl group, an unsubstituted or substituted monovalent hydrocarbon group, or an organooxy group, an acyl group, or a sulfonic acid group; and

x and y each, independently, represent an integer of 1 or more, and satisfy x + y ≤ 20.

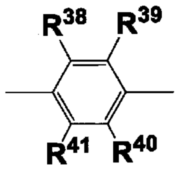

(6)

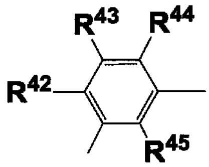

(7)

3. The charge transporting varnish according to claim 2, wherein $R^1$ and $R^2$ each, independently, represent a hydrogen atom or t-butoxycarbonyl group; $R^3$ to $R^{34}$ each, independently, represent a hydrogen atom, a substituted or unsubstituted monovalent hydrocarbon group, an organooxy group, an organoamino group, or a halogen atom; and m and n each, independently, represent an integer of 1 or more, and satisfy m + n ≤ 10.

4. The charge transporting varnish according to claim 2 or 3, wherein $R^3$ to $R^{34}$ each, independently, represent a hydrogen atom, a substituted or unsubstituted monovalent hydrocarbon group, or a halogen atom; and m and n each, independently, represent an integer of 1 or more and satisfy m + n ≤ 5.

5. The charge transporting varnish according to claim 3, wherein the monovalent hydrocarbon group in $R^3$ to $R^{34}$ is a phenyl group, a biphenyl group, a naphthyl group, or a substituted or unsubstituted arylamino group.

6. The charge transporting varnish according to claim 3, wherein the halogen atom is a fluorine atom.

7. The charge transporting varnish according to claim 2, wherein $R^3$ to $R^{34}$ are all hydrogen atoms.

8. A charge transporting varnish comprising a quinonediimine compound which is an oxidized form of the oligoaniline compound according to claim 2, an electron accepting dopant, a metal oxide nanoparticle and an organic solvent.

9. The charge transporting varnish according to any one of claims 1 to 8, wherein the electron accepting dopant material comprises at least one member selected from the group consisting of an arylsulfonic acid compound, a heteropoly

acid compound, and an ionic compound comprising an element belonging to Group 13 of the long periodic table.

**10.** The charge transporting varnish according to any one of claims 1 to 9, wherein the electron accepting dopant material comprises at least one selected from the group consisting of a heteropoly acid compound, an arylsulfonic acid derivative represented by formula (2), and an ionic compound consisting of an anion represented by formula (5a) and a countercation thereof.

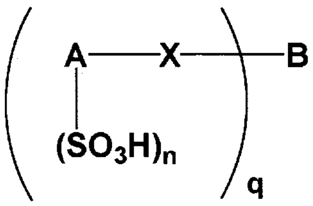

(2)

wherein

X represents O, S or NH;
A represents a naphthalene or anthracene ring which may have a substituent other than X or the n number of ($SO_3H$) groups;
B represents an unsubstituted or substituted hydrocarbon group, a 1,3,5-triazine group, or an unsubstituted or substituted group represented by formula (3) or (4) below:

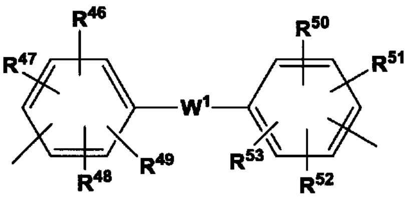

(3)

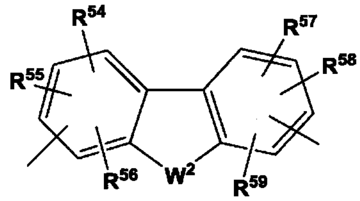

(4)

wherein

$W^1$ and $W^2$ each, independently, represent O, S, an S(O) group, an $S(O_2)$ group, or an unsubstituted or substituted N, Si, P, or P(O) group;
$W^1$ may be a single bond; and
$R^{46}$ to $R^{59}$ each, independently, represent a hydrogen atom or a halogen atom;

n represents the number of sulfonic acid groups attached to A and is an integer satisfying $1 \leq n \leq 4$; and
q represents the number of bonds between B and X and is an integer satisfying $1 \leq q$;

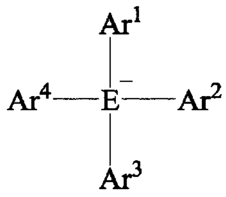

(5a)

wherein E represents an element belonging to Group 13 or 15 of the long periodic table; and $Ar^1$ to $Ar^4$ each, independently, represent an aromatic hydrocarbon group which may have a substituent or an aromatic heterocyclic group which may have a substituent.

**11.** A charge transporting film formed from the charge transporting varnish according to any one of claims 1 to 10.

**12.** An electronic device comprising the charge transporting film according to claim 11.

**13.** An organic electroluminescence device comprising the charge transporting film according to claim 11.

**14.** A method for producing a charge transporting film comprising: applying the charge transporting varnish according to any one of claims 1 to 10 onto a substrate and evaporating a solvent.

**15.** A charge transporting film comprising an oligoaniline compound and a metal oxide nanoparticle, wherein the average transmittance over the wavelength range of 400 nm to 800 nm is improved by the incorporation of the metal oxide nanoparticle.

**16.** A charge transporting film comprising an oligoaniline compound and a metal oxide nanoparticle, wherein the average transmittance over the wavelength range of 400 nm to 800 nm is 90% or more when deposited at a thickness of 50 nm on a quartz substrate.

FIG. 1

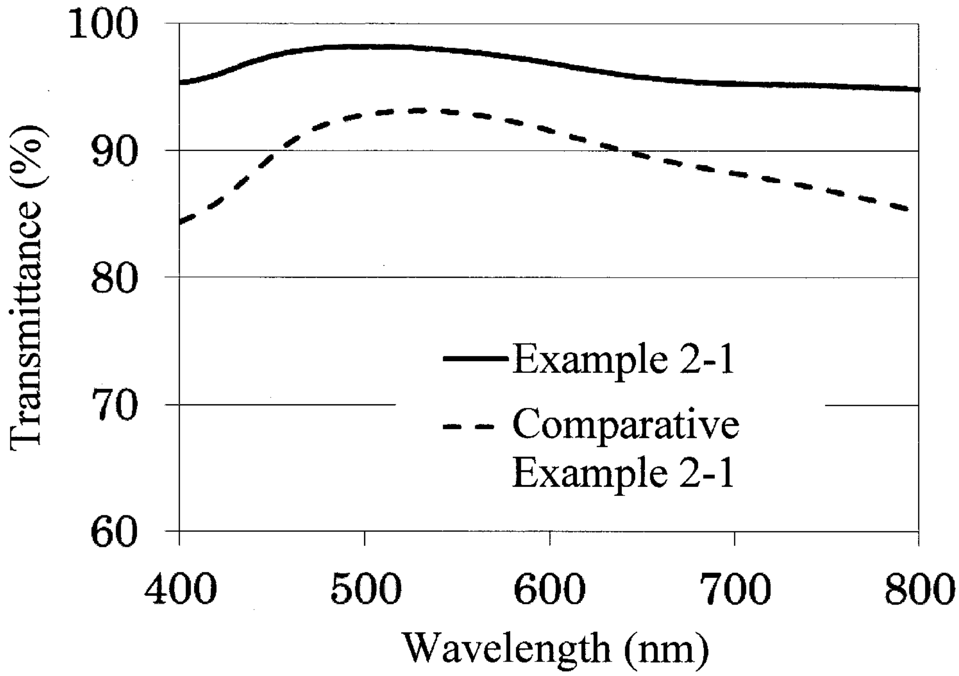
100
90
80
70
60
Transmittance (%)
400
500
600
700
800
Wavelength (nm)
Example 2-1
Comparative Example 2-1

FIG. 2

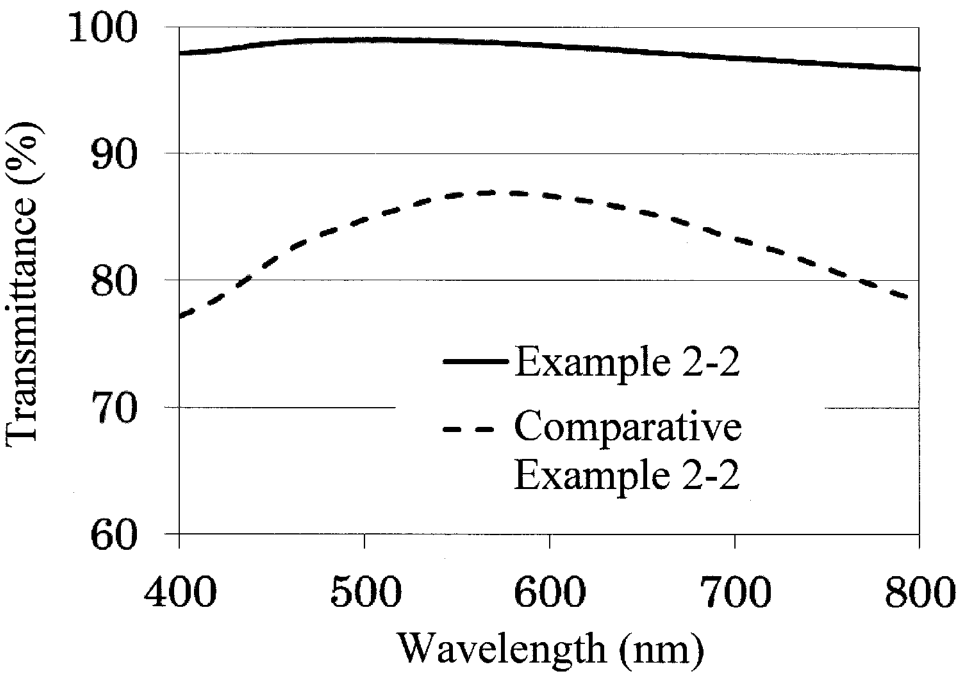
100
90
80
70
60
Transmittance (%)
400
500
600
700
800
Wavelength (nm)
Example 2-2
Comparative Example 2-2

## INTERNATIONAL SEARCH REPORT

International application No. PCT/JP2018/001380

A. CLASSIFICATION OF SUBJECT MATTER
Int.Cl. H01L51/50(2006.01)i, H05B33/10(2006.01)i

According to International Patent Classification (IPC) or to both national classification and IPC

B. FIELDS SEARCHED

Minimum documentation searched (classification system followed by classification symbols)
Int.Cl. H01L51/50, H05B33/10

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2011-193002 A (DU PONT) 29 September 2011, claims, paragraphs [0032]-[0037], [0059], examples 1-4 & US 2004/0206942 A1, claims, paragraphs [0031]-[0036], [0068], examples 1-4 & WO 2004/029176 A1 | 1, 8, 11-16<br>2-7, 9-10 |
| A | JP 2007-531807 A (DU PONT) 08 November 2007, claims, particularly, claim 7 & JP 5185615 B2 & US 2005/0224765 A1, claims, particularly, claim 7 & WO 2006/078264 A2 | 1-16 |

☒ Further documents are listed in the continuation of Box C.　☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10.04.2018 | 24.04.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No.
PCT/JP2018/001380

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 2012-23020 A (RICOH KK) 02 February 2012, claims, paragraphs [0048]-[0066], example 7 & US 2011/0309347 A1, claims, paragraphs [0062]-[0081], example 7 & EP 2398087 A1 & CN 102364716 A | 1, 11-16<br>2-10 |
| Y | WO 2008/129947 A1 (NISSAN CHEMICAL INDUSTRIES, LTD.) 30 October 2008, claims, entire text, compounds (12) (16) (25), formula (26) & US 2010/0230639 A1, claims, entire text, compounds (12) (16) (25), formula (26) & EP 2143708 A1 & CN 101679206 A & KR 10-2010-0016458 A | 2-10 |
| A | JP 2012-524834 A (DU PONT) 18 October 2012, claims, examples & US 2012/0145966 A1, claims, examples & WO 2010/124166 A2 & CN 102395627 A | 1-16 |
| A | WO 2010/058777 A1 (NISSAN CHEMICAL INDUSTRIES, LTD.) 27 May 2010, claims, entire text & JP 2014-131057 A & JP 2015-146438 A | 1-16 |
| A | JP 2012-520381 A (DU PONT) 06 September 2012, claims, examples & US 2012/0175596 A1, claims, examples & WO 2010/105140 A2 & CN 102349115 A | 1-16 |
| A | JP 2005-347271 A (LG ELECTRONICS INC.) 15 December 2005, claims & US 2005/0271898 A1, claims & EP 1603174 A2 & CN 1717136 A | 1-16 |
| A | WO 2015/125721 A1 (NISSAN CHEMICAL INDUSTRIES, LTD.) 27 August 2015, claims, entire text & CN 106030843 A & KR 10-2016-0123347 A | 1-16 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2017006991 A
- JP 2017126778 A
- WO 2008129947 A
- WO 2008032616 A
- JP 2012524834 W
- JP 2012520381 W
- JP 5381931 B
- JP 2002151272 A
- WO 2002151272 A
- WO 2005000832 A
- WO 2006025342 A
- JP 2005108828 A
- WO 2013084664 A

### Non-patent literature cited in the description

- *Advanced Materials,* 2011, vol. 23 (6), 740-745